# EUROPEAN PATENT APPLICATION

(11) **EP 4 800 837 A1**
(43) Date of publication of application: **02.09.2026**
(21) Application number: 24913522.9
(22) Date of filing: 23.12.2024
(51) Int. Cl.: H01Q 1/22, H01Q 1/38, H01Q 9/04, H01Q 1/52, H05K 1/02, H01L 23/66, H04M 1/02, H05K 1/11

(54) **ELECTRONIC DEVICE COMPRISING CHIP ANTENNA**

(30) Priority: 29.12.2023 KR 20230197969; 30.01.2024 KR 20240014440
(71) Applicant: Samsung Electronics Co., Ltd., Suwon-si, Gyeonggi-do 16677 (KR)
(72) Inventor: YUN, Sumin, Suwon-si Gyeonggi-do 16677 (KR); KWON, Soonheung, Suwon-si Gyeonggi-do 16677 (KR); KIM, Junggil, Suwon-si Gyeonggi-do 16677 (KR); KIM, Hosaeng, Suwon-si Gyeonggi-do 16677 (KR); AN, Chankyu, Suwon-si Gyeonggi-do 16677 (KR); LEE, Kookjoo, Suwon-si Gyeonggi-do 16677 (KR); LEE, Hyungjoo, Suwon-si Gyeonggi-do 16677 (KR); HONG, Sukgi, Suwon-si Gyeonggi-do 16677 (KR)
(74) Representative: HGF
(86) International application number: PCT/KR2024/020992
(87) International publication number: WO 2025/143731

(57) **Abstract**

An electronic device according to one embodiment may comprise: a printed circuit board; a chip antenna arranged on the printed circuit board; a conductive member which includes a cover portion that is positioned on the chip antenna and includes a first opening aligned with the chip antenna, and which is arranged on the printed circuit board; a nonmetallic layer arranged on the cover portion so as to close the first opening; and a shielding layer arranged on the nonmetallic layer. The shielding layer can include a second opening aligned with the first opening of the cover portion.

## Description

### [Technical Field]

The disclosure relates to an electronic device including a chip antenna.

### [Background Art]

An electronic device such as a smartphone may include an antenna for wireless communication. The electronic device may provide various services, such as detecting peripheral devices and controlling door locks of a vehicle or a house, using antennas used for wireless communication technology such as ultra-wide band (UWB).

The above information is presented as related art only to assist with an understanding of the disclosure. No determination has been made, and no assertion is made, as to whether any of the above might be applicable as prior art with regard to the disclosure.

### [Detailed Description of Invention]

### [Technical Solution]

An electronic device according to an embodiment may include a printed circuit board, a chip antenna disposed on the printed circuit board, a conductive member disposed on the printed circuit board and including a cover portion positioned over the chip antenna, the cover portion including a first opening aligned with the chip antenna, a non-conductive layer disposed on the cover portion to close the first opening, and a shielding layer disposed on the non-conductive layer. The shielding layer may include a second opening aligned with the first opening of the cover portion.

### [Brief Description of Drawings]

FIG. 1 is a block diagram of an electronic device in a network environment according to various embodiments.
FIG. 2A is a diagram illustrating an example electronic device according to an embodiment.
FIG. 2B is an exploded perspective view of an example electronic device according to an embodiment.
FIG. 3 is a view for explaining tilting of a beam pattern according to a position where a chip antenna is disposed on a printed circuit board.
FIG. 4 illustrates radiation patterns according to positions of a chip antenna.
FIG. 5 illustrates current distribution in a case where a chip antenna is located at the center of a printed circuit board.
FIG. 6A illustrates current distribution in a case where a chip antenna is located near an edge of a printed circuit board.
FIG. 6B illustrates current distribution in a case where a chip antenna is located near an edge of a printed circuit board.
FIG. 7A exemplarily illustrates a chip antenna disposed on a printed circuit board, according to an embodiment.
FIG. 7B exemplarily illustrates a chip antenna disposed on a printed circuit board, according to an embodiment.
FIG. 8A exemplarily illustrates a chip antenna disposed on a printed circuit board, according to an embodiment.
FIG. 8B exemplarily illustrates a chip antenna disposed on a printed circuit board, according to an embodiment.
FIG. 8C illustrates current distribution of a chip antenna disposed on a printed circuit board, according to an embodiment.
FIG. 9 is a view illustrating radiation patterns of a chip antenna.
FIG. 10A is a cross-sectional view of an electronic device according to an embodiment.
FIG. 10B is a cross-sectional view of an electronic device according to an embodiment.
FIG. 10C is a cross-sectional view of an electronic device according to an embodiment.
FIG. 11A exemplarily illustrates a printed circuit board on which a chip antenna is disposed, according to an embodiment.
FIG. 11B exemplarily illustrates an electronic device including a printed circuit board on which a conductive member is disposed, according to an embodiment.
FIG. 11C exemplarily illustrates an electronic device including an antenna module disposed on a conductive member.
FIG. 11D is a cross-sectional view taken along line C-C' of FIG. 11C.
FIG. 11E illustrates radiation patterns of a chip antenna according to an embodiment.
FIG. 12A exemplarily illustrates an electronic device including a printed circuit board on which a conductive member is disposed, according to an embodiment.
FIG. 12B illustrates current distribution of an electronic device, according to an embodiment.
FIG. 13 is a view illustrating an alignment relationship between a chip antenna and an opening of a conductive member, according to an embodiment.
FIG. 14A illustrates a radiation pattern in a case where a chip antenna is offset-aligned with respect to an opening, according to an embodiment.
FIG. 14B illustrates a radiation pattern in a case where a chip antenna is aligned with the center of an opening, according to an embodiment.
FIG. 15A is an exemplary view illustrating an electronic device according to an embodiment.
FIG. 15B is a cross-sectional view taken along line D-D' of FIG. 15A.
FIG. 16A is an exemplary view illustrating an electronic device according to an embodiment.
FIG. 16B is a cross-sectional view taken along line E-E' of FIG. 16A.
FIG. 17 is a view illustrating a chip antenna according to an embodiment.
FIG. 18A illustrates current distribution of a chip antenna forming a first polarization according to an embodiment.
FIG. 18B illustrates current distribution of a chip antenna forming a second polarization according to an embodiment.

### [Mode for Carrying out the Invention]

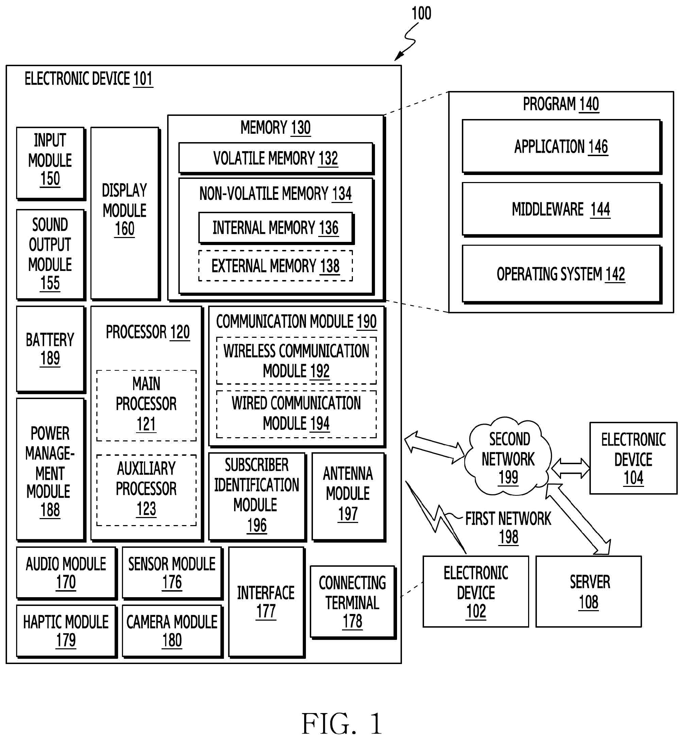

FIG. 1 is a block diagram of an electronic device in a network environment according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In an embodiment, at least one of the components (e.g., the connecting terminal 178) may be omitted from the electronic device 101, or one or more other components may be added in the electronic device 101. In an embodiment, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may, for example, control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but the disclosure is not limited thereto. The artificial intelligence model may, additionally or alternatively, include a software structure other than the hardware structure.

The memory 130 may store various data used by at least one component (e.g., the processor 120 or the sensor module 176) of the electronic device 101. The data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., the electronic device 102)(e.g., speaker or headphone) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra-low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

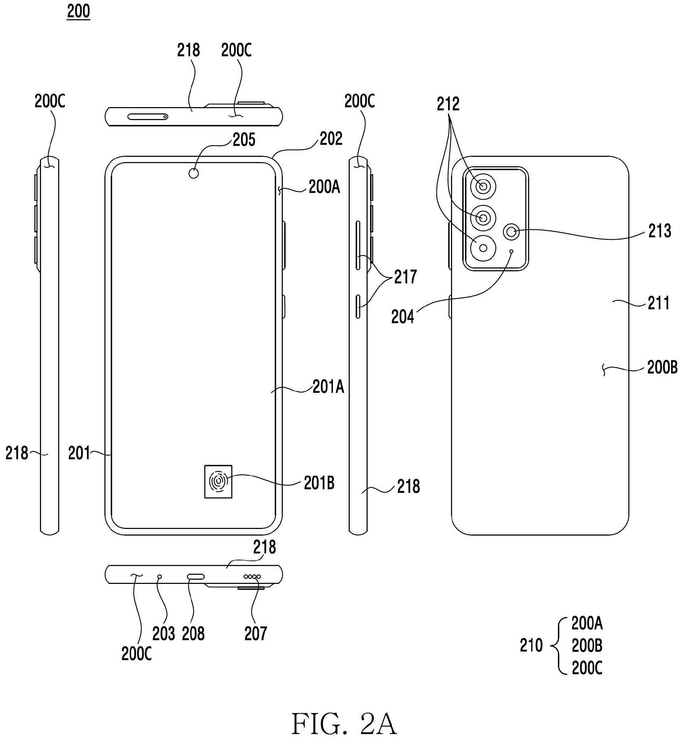

FIG. 2A illustrates an example electronic device according to an embodiment. Referring to FIG. 2A, an electronic device 200 according to an embodiment may include a housing 210 forming an appearance of the electronic device 200. For example, the housing 210 may include a first surface (or front surface) 200A, a second surface (or rear surface) 200B, and a third surface (or lateral surface) 200C surrounding a space between the first surface 200A and the second surface 200B. In an embodiment, the housing 210 may refer to a structure forming at least a portion of a first surface 200A, a second surface 200B, and/or third surfaces 200C.

An electronic device 200 according to an embodiment may include a substantially transparent front plate 202. In an embodiment, the front plate 202 may form at least a portion of a first surface 200A. In an embodiment, the front plate 202 may include, for example, a glass plate or a polymer plate including various coating layers, but the disclosure is not limited thereto.

The electronic device 200 according to an embodiment may include a substantially opaque rear plate 211. In an embodiment, the rear plate 211 may form at least a portion of the second surface 200B. In an embodiment, the rear plate 211 may be formed by coated or colored glass, ceramic, polymer, metal (e.g., aluminum, stainless steel (STS), or magnesium), or a combination of at least two of the above materials.

The electronic device 200 according to an embodiment may include a side bezel structure (e.g., a side member or a bracket) 218. In an embodiment, the side bezel structure 218 may be coupled with the front plate 202 and/or the rear plate 211 to form at least a portion of the third surface 200C of the electronic device 200. For example, the side bezel structure 218 may form the entirety of the third surface 200C of the electronic device 200, or in another example, the side bezel structure 218 may form the third surface 200C of the electronic device 200 together with the front plate 202 and/or the rear plate 211.

Unlike the illustrated embodiment, in a case where the third surface 200C of the electronic device 200 is partially formed by the front plate 202 and/or the rear plate 211, the front plate 202 and/or the rear plate 211 may include a portion that curves and extends toward the rear plate 211 and/or the front plate 202 at an edge thereof. The extending portion of the front plate 202 and/or the rear plate 211 may be located, for example, at both ends of a long edge of the electronic device 200, but the disclosure is not limited by the above-described example.

In an embodiment, the side bezel structure 218 may include metal and/or polymer. In an embodiment, the rear plate 211 and the side bezel structure 218 may be integrally formed and may include the same material (e.g., a metal material such as aluminum), but are not limited thereto. For example, the rear plate 211 and the side bezel structure 218 may be formed as separate structures and/or may include different materials from each other.

In an embodiment, the electronic device 200 may include a display 201 (e.g., the display module 160 of FIG. 1), audio modules 203, 204, and 207 (e.g., the audio module 170 of FIG. 1), a sensor module (e.g., the sensor module 176 of FIG. 1), camera modules 205, 212, and 213 (e.g., the camera module 180 of FIG. 1), a key input device 217 (e.g., the input module 150 of FIG. 1), a light-emitting element (not shown), and a connector hole 208. In an embodiment, the electronic device 200 may omit at least one of the components (e.g., the key input device 217 or the light-emitting element not shown) or may additionally include other components.

In an embodiment, the display 201 may be visually exposed through a substantial portion of the front plate 202. For example, at least a portion of the display 201 may be visible through the front plate 202 forming the first surface 200A. The display 201 may be disposed on a rear surface of the front plate 202.

In an embodiment, in order to expand an area where the display 201 is visually exposed, an outer shape of the display 201 may be formed to be substantially the same as an outer shape of the front plate 202 adjacent to the display 201. In an embodiment, a gap between the periphery of the display 201 and the periphery of the front plate 202 may be formed to be substantially the same.

In an embodiment, the display 201 (or the first surface 200A of the electronic device 200) may include a screen display area 201A. In an embodiment, the display 201 may provide visual information to a user via the screen display area 201A. In the embodiment illustrated, when the first surface 200A is viewed from the front, the screen display area 201A is illustrated as being spaced apart from the periphery of the first surface 200A and located within the first surface 200A, but the disclosure is not limited thereto. For example, when the first surface 200A is viewed from the front, at least a portion of an edge of the screen display area 201A may substantially coincide with an edge of the first surface 200A (or the front plate 202).

In an embodiment, the screen display area 201A may include a sensing area 201B configured to obtain biometric information of a user. Here, the meaning of "the screen display area 201A including the sensing area 201B" may be understood as at least a portion of the sensing area 201B being capable of overlapping the screen display area 201A. For example, the sensing area 201B may refer to an area capable of displaying visual information by the display 201, like other areas of the screen display area 201A, and additionally obtaining biometric information (e.g., a fingerprint) of the user. Although the sensing area 201B is illustrated as being formed within the screen display area 201A, the disclosure is not limited thereto. For example, the sensing area 201B may be formed in the key input device 217.

In an embodiment, the display 201 may include an area where a first camera module 205 is located. For example, an opening is formed in the area of the display 201, and the first camera module 205 (e.g., a punch-hole camera) may be at least partially disposed within the opening to face the first surface 200A. In such a case, the screen display area 201A may surround at least a portion of a periphery of the opening. In an embodiment, the first camera module 205 (e.g., an under-display camera, UDC) may be disposed underneath the display 201 to overlap the area of the display 201. In this case, the display 201 may provide visual information to the user via the area, and additionally, the first camera module 205 may obtain an image corresponding to a direction toward the first surface 200A via the area of the display 201.

In an embodiment, the display 201 may be coupled with or disposed adjacent to a touch sensing circuit, a pressure sensor capable of measuring the intensity (pressure) of a touch, and/or a digitizer for detecting a magnetic field-type stylus pen.

In an embodiment, the audio modules 203, 204, and 207 may include microphone holes 203 and 204 and a speaker hole 207.

In an embodiment, the microphone holes 203 and 204 may include a first microphone hole 203 formed in a partial area of the third surface 200C and a second microphone hole 204 formed in a partial area of the second surface 200B. A microphone (not shown) for obtaining external sound may be disposed inside the microphone holes 203 and 204. The microphone may include a plurality of microphones so as to sense the direction of sound, but the disclosure is not limited thereto.

In an embodiment, the second microphone hole 204 formed in a partial area of the second surface 200B may be disposed to be adjacent to the camera modules 205, 212, and 213. For example, the second microphone hole 204 may obtain sound according to the operation of the camera modules 205, 212, and 213. However, the disclosure is not limited thereto.

In an embodiment, the speaker hole 207 may include an external speaker hole 207 and a receiver hole for calls (not shown). The external speaker hole 207 may be formed in a portion of the third surface 200C of the electronic device 200. In an embodiment, the external speaker hole 207 may be integrated into the microphone hole 203, and the speaker hole 207 and the microphone hole 203 may be implemented as one hole. Although not shown herein, the receiver hole for calls (not shown) may be formed in another portion of the third surface 200C. For example, the receiver hole for calls may be formed on the opposite side of the external speaker hole 207 on the third surface 200C. For example, based on the illustration of FIG. 2A, the external speaker hole 207 may be formed on the third surface 200C corresponding to a lower end of the electronic device 200, and the receiver hole for calls may be formed on the third surface 200C corresponding to an upper end of the electronic device 200. However, the disclosure is not limited thereto, and in another embodiment, the receiver hole for calls may be formed at a position other than the third surface 200C. For example, the receiver hole for calls may be formed by a spaced space between the front plate 202 (or the display 201) and the side bezel structure 218.

In an embodiment, the electronic device 200 may include at least one speaker (not shown) (e.g., the sound output module 155 of FIG. 1) configured to output sound to the outside of the housing 210 through the external speaker hole 207 and/or the receiver hole for calls (not shown).

In an embodiment, the sensor module (not shown) may generate electrical signals or data values corresponding to an internal operating state of the electronic device 200 or an external environmental state. For example, the sensor module may include at least one of a proximity sensor, an HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera modules 205, 212, and 213 may include a first camera module 205 disposed to face the first surface 200A of the electronic device 200, a second camera module 212 disposed to face the second surface 200B, and a flash 213.

In an embodiment, the second camera module 212 may include a plurality of cameras (e.g., a dual camera, a triple camera, or a quad camera). However, the second camera module 212 is not necessarily limited to including a plurality of cameras and may include a single camera.

In an embodiment, the first camera module 205 and the second camera module 212 may include one or a plurality of lenses, an image sensor, and/or an image signal processor.

In an embodiment, the flash 213 may include, for example, a light-emitting diode or a xenon lamp. In an embodiment, two or more lenses (infrared camera, wide-angle and telephoto lenses) and image sensors may be disposed on one surface of the electronic device 200.

In an embodiment, the key input devices 217 may be disposed on the third surface 200C of the electronic device 200. In an embodiment, the electronic device 200 may not include some or all of the key input devices 217, and the key input device 217 not included therein may be implemented in another form such as e.g., a soft key on the display 201.

In an embodiment, the connector hole 208 may be formed on the third surface 200C of the electronic device 200 so that a connector of an external device may be accommodated therein. A connection terminal (e.g., the connection terminal 178 of FIG. 1) electrically connected to the connector of the external device may be disposed in the connector hole 208. The electronic device 200 according to an embodiment may include an interface module (e.g., the interface 177 of FIG. 1) for processing electrical signals transmitted and received via the connection terminal.

In an embodiment, the electronic device 200 may include a light-emitting element (not shown). For example, the light-emitting element (not shown) may be disposed on the first surface 200A of the housing 210. The light-emitting element (not shown) may provide state information of the electronic device 200 in the form of light. In an embodiment, the light-emitting element (not shown) may provide a light source associated with the operation of the first camera module 205. For example, the light-emitting element (not shown) may include an LED, an IR LED, and/or a xenon lamp.

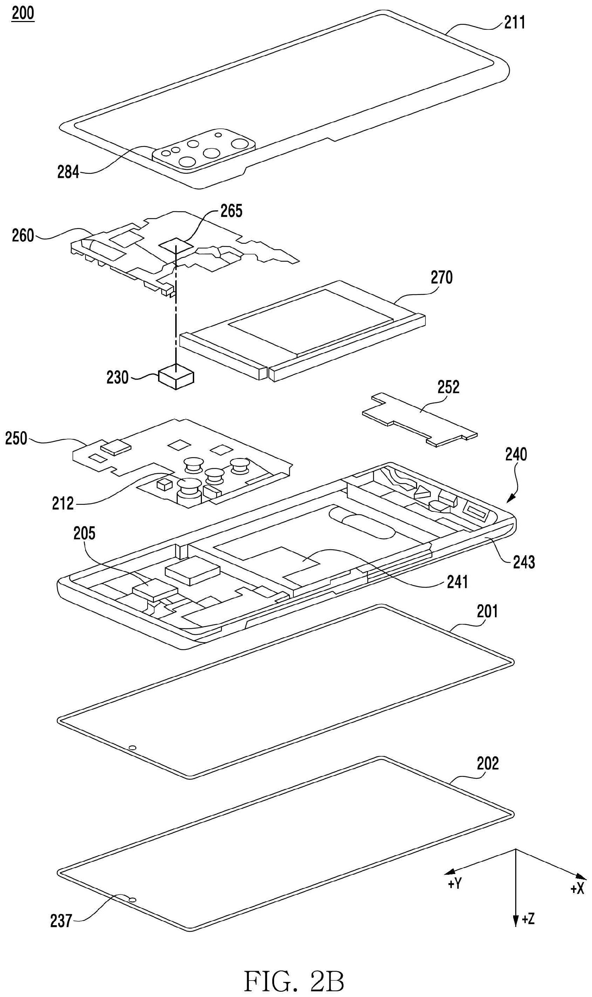

FIG. 2B is an exploded perspective view of an example electronic device according to an embodiment. Referring to FIG. 2B, the electronic device 200 according to an embodiment may include a frame structure 240 (e.g., the side bezel structure 218 of FIG. 2A), a first printed circuit board 250, a second printed circuit board 252, a cover plate 260, a chip antenna 230 (e.g., the antenna module 197 of FIG. 1), and a battery 270 (e.g., the battery 189 of FIG. 1).

In an embodiment, the frame structure 240 may be located between the display 201 and the rear plate 211. In an embodiment, the frame structure 240 may support or accommodate components included in the electronic device 200. For example, the display 201 may be disposed on one surface of the frame structure 240 facing one direction (e.g., +Z direction). The first printed circuit board 250, the second printed circuit board 252, the battery 270, and the second camera module 212 may be disposed on the other surface of the frame structure 240 facing a direction opposite to the one direction (e.g., -Z direction). The first printed circuit board 250, the second printed circuit board 252, the battery 270, and the second camera module 212 may be disposed within a recess formed in the frame structure 240.

In an embodiment, the frame structure 240 may include a first part 241 and a second part 243 surrounding the first part 241. The first part 241 may be located underneath the display 201 (e.g., -Z direction) to support the display 201. Alternatively, the first part 241 may support the display 201 together with the second part 243. The second part 243 may surround a space between the rear plate 211 and the front plate 202 (and/or the display 201). The second part 243 surrounding the space may form a lateral surface (e.g., the third surface 200C of FIG. 2A) of the electronic device 200, and the first part 241 located within the space may extend inward from the second part 243. The lateral surface may extend from the front surface (e.g., the first surface 200A of FIG. 2A) of the electronic device 200 or a periphery of the front plate 202. In an embodiment, the first part 241 and the second part 243 may be formed of metal and/or polymer. The frame structure 240 or the first part 241 of the frame structure 240 may be referred to as a support member.

In an embodiment, the first printed circuit board 250, the second printed circuit board 252, and the battery 270 may be coupled to the frame structure 240, respectively. For example, the first printed circuit board 250 and the second printed circuit board 252 may be fixedly disposed on the frame structure 240 with a coupling member such as a screw. For example, the battery 270 may be fixedly disposed on the frame structure 240 with an adhesive member (e.g., double-sided tape). However, the disclosure is not limited to the above-described example.

In an embodiment, the display 201 may be disposed between the frame structure 240 and the front plate 202. For example, the front plate 202 may be disposed on one side (e.g., +Z direction) of the display 201, and the frame structure 240 may be disposed on the other side (e.g., -Z direction).

In an embodiment, the front plate 202 may be coupled to the display 201. For example, the display 201 may be attached to the rear surface of the front plate 202 with an optical adhesive member (e.g., optically clear adhesive (OCA) or optically clear resin (OCR)).

In an embodiment, the front plate 202 may be coupled to the frame structure 240. For example, the front plate 202 may include an outer portion extending out of the display 201 when viewed in the z-axis direction. The frame structure 240 (e.g., the second part 243) may be attached to the outer portion, but the disclosure is not limited thereto.

In an embodiment, a processor (e.g., the processor 120 of FIG. 1), a memory (e.g., the memory 130 of FIG. 1), and/or an interface (e.g., the interface 177 of FIG. 1) may be disposed on the first printed circuit board 250 and/or the second printed circuit board 252. The processor may include, for example, one or more of a central processing unit, an application processor, a graphic processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 200 with an external electronic device, and may include a USB connector, an SD card/MMC connector, or an audio connector. In an embodiment, the first printed circuit board 250 and the second printed circuit board 252 may be operatively or electrically connected to each other via a connection member (e.g., a flexible printed circuit board).

In an embodiment, a cover plate 260 may be disposed between the first printed circuit board 250 and the rear plate 211. In an embodiment, the cover plate 260 may be disposed on the first printed circuit board 250. For example, the cover plate 260 may be disposed on a surface of the first printed circuit board 250 facing the -Z direction.

In an embodiment, the cover plate 260 may at least partially overlap the first printed circuit board 250 on the basis of the z-axis. In an embodiment, the cover plate 260 may cover at least a partial area of the first printed circuit board 250. Using this structure, the cover plate 260 may protect the first printed circuit board 250 from physical shock or prevent separation of a connector coupled to the first printed circuit board 250.

In an embodiment, the cover plate 260 may be fixedly disposed onto the first printed circuit board 250 with a coupling member (e.g., a screw), or may be coupled to the frame structure 240 together with the first printed circuit board 250 via the coupling member. For example, the cover plate 260 may be coupled to the first printed circuit board 250 and/or the frame structure 240 so as to be located on or above the first printed circuit board 250.

In an embodiment, the cover plate 260 may include a conductive portion. Additionally, the cover plate 260 may include a non-conductive portion. For example, the conductive portion of the cover plate 260 may be formed of a conductive metal such as stainless steel, and the non-conductive portion may be formed of a non-conductive material such as plastic. For example, the conductive portion of the cover plate 260 may be referred to as conductive members 760, 860, 1060, 1160, 1260, 1560, or 1660, which will be described later. The non-conductive portion of the cover plate 260 may be referred to as non-conductive members 1590 or 1690, which will be described later.

In an embodiment, the cover plate 260 may include an opening 265. The opening 265 may be formed to penetrate the cover plate 260. The opening 265 may be aligned with a chip antenna 230 disposed on the printed circuit board 250. For example, the opening 265 may overlap the chip antenna 230. For example, the opening 265 may overlap the chip antenna 230 on the basis of the Z direction.

In an embodiment, the opening 265 may be referred to as openings 765, 865, 1065, 1165, 1265, 1565, or 1665, which will be described later. In an embodiment, the opening 265 may be formed within the conductive portion of the cover plate 260. For example, the opening 265 may be formed within conductive members 760, 860, 1060, 1160, 1260, or 1560, like openings 765, 865, 1065, 1165, 1265, or 1565, which will be described later. Alternatively, the opening 265 may be formed between the non-conductive portion and the conductive portion of the cover plate 260. For example, the opening 265 may be formed between a conductive member 1660 and a non-conductive member 1690, like an opening 1665, which will be described later.

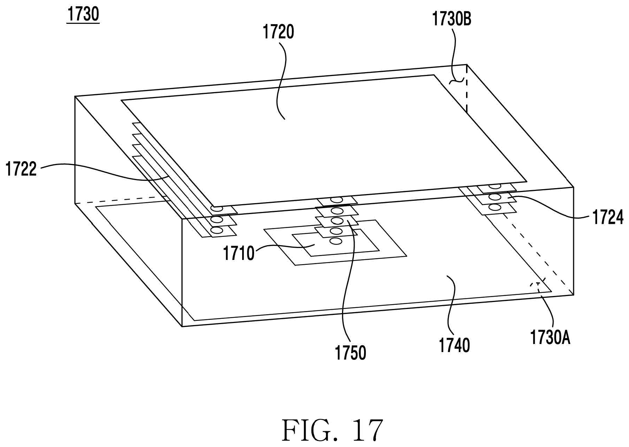

In an embodiment, the chip antenna 230 may be disposed on the printed circuit board 250. For example, the chip antenna 230 may be disposed on the printed circuit board 250 using a surface mount device (SMD). The chip antenna 230 may be located between the printed circuit board 250 and the cover plate 260. In an embodiment, a wireless communication circuit of the electronic device 200 (e.g., the wireless communication module 192 of FIG. 1) may transmit and/or receive a radio frequency (RF) signal, using the chip antenna 230. For example, the RF signal may include an ultra-wide band (UWB) signal, but the disclosure is not limited thereto. In an embodiment, the chip antenna 230 may include a low temperature co-fired ceramic (LTCC) type of antenna. A detailed configuration of the chip antenna 230 will be described later with reference to FIG. 17.

In an embodiment, a battery 270 may supply power to at least one component of the electronic device 200. For example, the battery 270 may include a rechargeable secondary battery or a fuel cell.

In an embodiment, a first camera module 205 (e.g., a front camera) may be disposed in at least a portion of the frame structure 240 (e.g., a first part 241) such that a lens can receive external light through a partial area (e.g., a camera area 237) of the front plate 202 (e.g., the front surface 200A of FIG. 2A).

In an embodiment, a second camera module 212 (e.g., a rear camera) may be disposed between the frame structure 240 and the rear plate 211. In an embodiment, the second camera module 212 may be electrically connected to the first printed circuit board 250 via a connection member (e.g., a connector). In an embodiment, the second camera module 212 may be disposed such that a lens can receive external light through a camera area 284 of the rear plate 211 of the electronic device 200.

In an embodiment, the camera area 284 may be formed on a surface of the rear plate 211 (e.g., the rear surface 200B of FIG. 2A). In an embodiment, the camera area 284 may be formed to be at least partially transparent so that external light can be incident on the lens of the second camera module 212. In an embodiment, at least a portion of the camera area 284 may protrude from the surface of the rear plate 211 to a predetermined height. However, the disclosure is not limited thereto, and in another embodiment, the camera area 284 may form substantially the same plane as the surface of the rear plate 211.

In an embodiment, the housing 210 of the electronic device 200 may refer to a configuration or structure forming at least a portion of an exterior of the electronic device 200. In this regard, at least a portion of the front plate 202, the frame structure 240, and/or the rear plate 211 forming the exterior of the electronic device 200 may be referred to as the housing 210 of the electronic device 200.

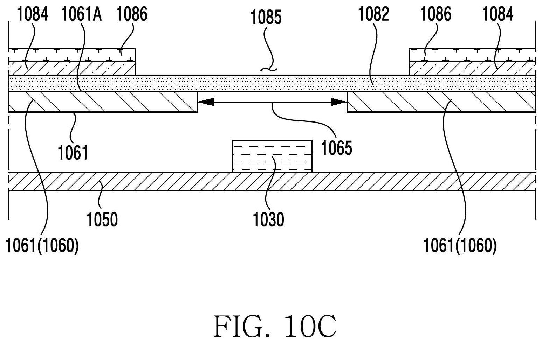

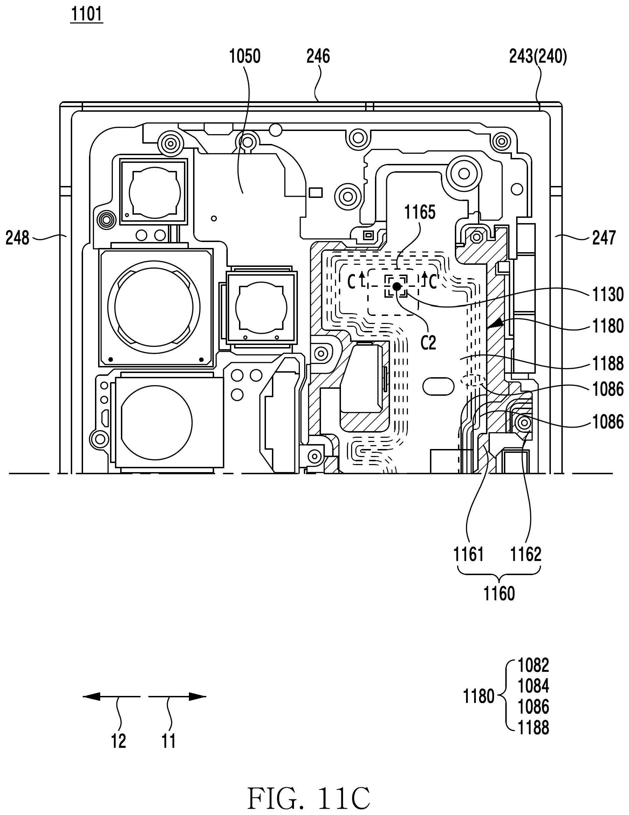

The electronic device 200 according to an embodiment may include an antenna module (not shown) (e.g., a cover layer 1180 of FIG. 11C). In an embodiment, the antenna module may be disposed between the rear plate 211 and the cover plate 260. The antenna module may include, for example, a near field communication (NFC) antenna (e.g., an antenna pattern 1086 of FIG. 10C), a wireless charging antenna, and/or a magnetic secure transmission (MST) antenna. The antenna module may, for example, perform short-range communication with an external device or wirelessly transmit and receive power to and from an external device.

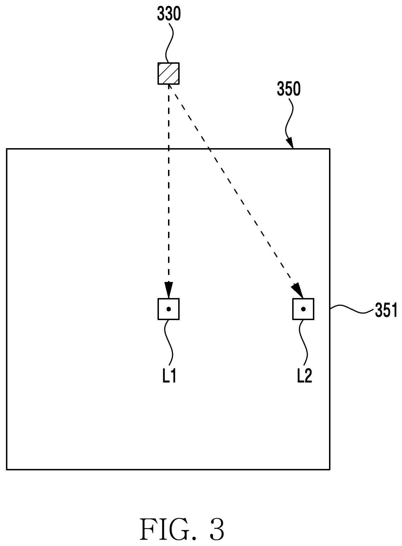

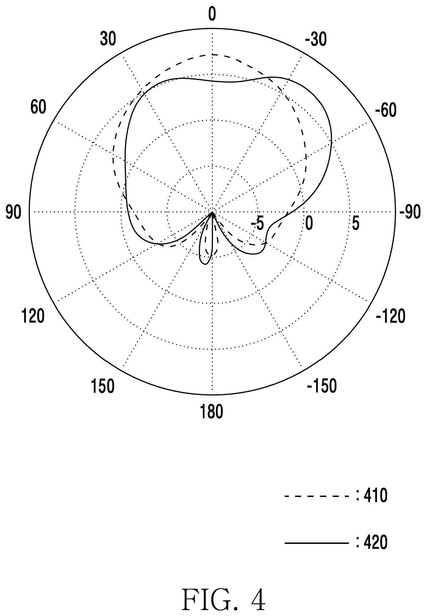

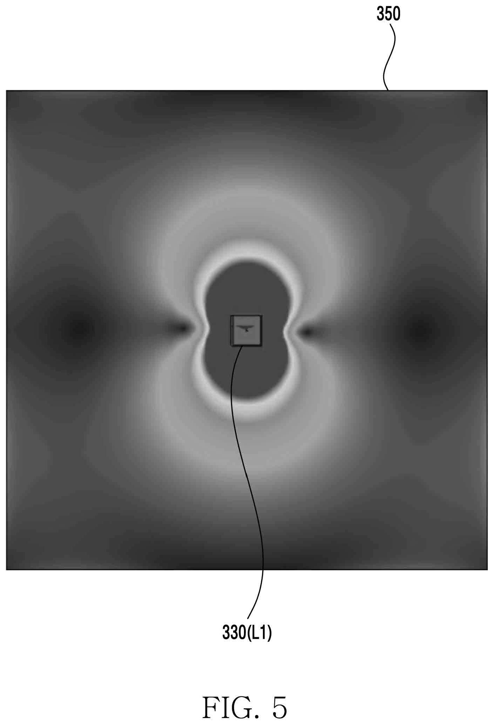

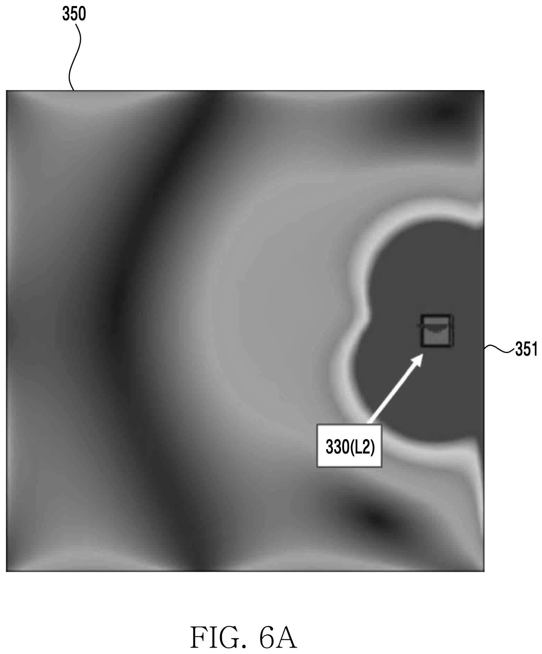

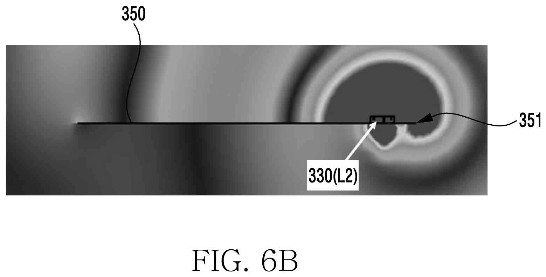

FIG. 3 is a view for explaining tilting of a beam pattern depending on a position where a chip antenna is disposed on a printed circuit board. FIG. 4 illustrates radiation patterns depending on to positions of a chip antenna. FIG. 5 illustrates current distribution in a case where a chip antenna is located at the center of a printed circuit board. FIGS. 6A and 6B illustrate current distribution in a case where a chip antenna is located near an edge of a printed circuit board.

Referring to FIG. 3, a chip antenna 330 (e.g., the chip antenna 230 of FIG. 2B) may be disposed on a printed circuit board 350 (e.g., the printed circuit board 250 of FIG. 2B). For example, the chip antenna 330 may be disposed at a first position L1 corresponding to the center of the printed circuit board 350 or at a second position L2 near an edge 351 of the printed circuit board 350.

A ground condition of the chip antenna 330 may vary depending on a position where the chip antenna 330 is disposed on the printed circuit board 350. Accordingly, a resonant frequency of the chip antenna 330 may be shifted, or its antenna efficiency may be changed. Due to the asymmetry of the ground according to the position of the chip antenna 330, a radiation pattern of the chip antenna 330 may be tilted in any one direction. For example, as shown in FIG. 4, a radiation pattern 420 of the chip antenna 330 at the second position L2 may be tilted in the direction of -90 degrees as a whole, compared to a radiation pattern 410 of the chip antenna 330 at the first position L1. For example, referring to FIG. 5, in a case where the chip antenna 330 is located at the center of the printed circuit board 350, the radiation pattern of the chip antenna 330 may be uniformly formed as a whole, without being biased in either direction. In contrast, referring to FIGS. 6A and 6B, in a case where the chip antenna 330 is disposed in the vicinity of the edge 351 of the printed circuit board 350, the radiation pattern of the chip antenna 330 may be tilted toward a lateral surface (e.g., a direction in which the edge 351 faces) of the printed circuit board 350. This may be because current is formed asymmetrically about the chip antenna 330. In a case where the radiation pattern is tilted, a performance deviation of the chip antenna 330 may occur depending on the direction, and performance of a service provided using UWB technology, such as detection of peripheral devices, may vary.

In order to reduce tilting of the radiation pattern of the chip antenna 330, the chip antenna 330 may be disposed at the center of the printed circuit board 350. However, since various components as well as the chip antenna 330 are disposed on the printed circuit board 350, it may be difficult to arrange the chip antenna 330 at the center of the printed circuit board 350. Further, the operating characteristics of the chip antenna 330 may be changed due to influences of other components disposed on the printed circuit board 350, and thus the position of the chip antenna 330 should be determined in consideration of such influences.

Hereinafter, an arrangement structure of the chip antenna that may minimize influences due to beam tilting and other components will be described with reference to the following drawings.

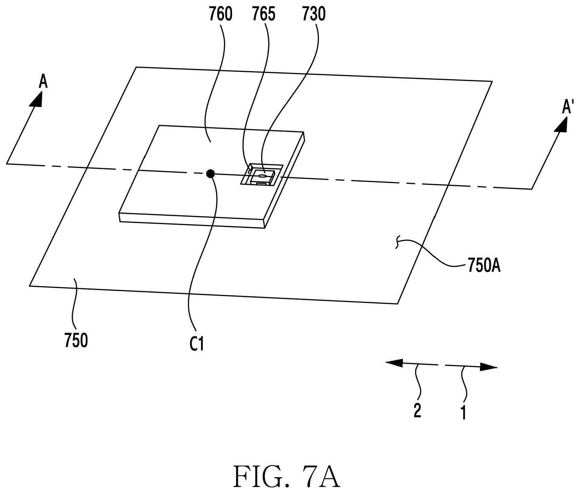

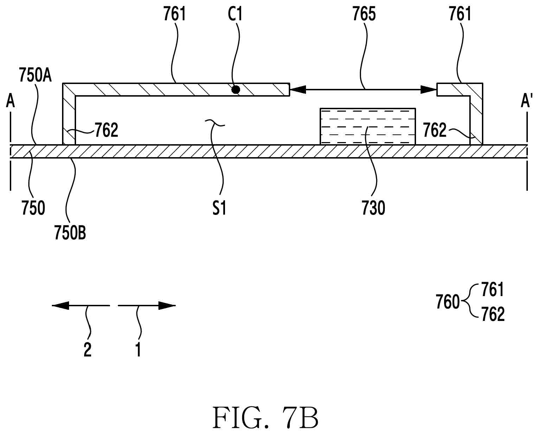

FIGS. 7A and 7B illustrate an example chip antenna disposed on a printed circuit board, according to an embodiment. FIG. 7B may be a cross-sectional view taken along line A-A' of FIG. 7A.

Referring to FIGS. 7A and 7B, an electronic device (e.g., the electronic device 200 of FIG. 2B) according to an embodiment may include a printed circuit board 750 (e.g., the printed circuit board 250 of FIG. 2B), a chip antenna 730 (e.g., the chip antenna 230 of FIG. 2B), and a conductive member 760 (e.g., the cover plate 260 or a conductive portion of the cover plate 260 of FIG. 2B, or a shield can).

In an embodiment, the printed circuit board 750 may include a first surface 750A and a second surface 750B opposite to the first surface 750A. For example, the chip antenna 730 may be disposed on the first surface 750A of the printed circuit board 750.

In an embodiment, the conductive member 760 may be disposed on the printed circuit board 750. For example, the conductive member 760 may be disposed on the first surface 750A of the printed circuit board 750. As another example, the conductive member 760 may be located to cover at least a portion of the printed circuit board 750. For example, the conductive member 760 may be disposed on the first surface 750A of the printed circuit board 750 so as to cover the chip antenna 730. In an embodiment, the conductive member 760 may at least partially surround the chip antenna 730. The conductive member 760 may define an internal space S1 together with the first surface 750A of the printed circuit board 750. The chip antenna 730 may be located within the internal space S1.

In an embodiment, the conductive member 760 may include a first portion 761 and a second portion 762. In an embodiment, the first portion 761 may extend from an upper end of the second portion 762. The first portion 761 may be spaced apart from the printed circuit board 750. The first portion 761 may be located above the chip antenna 730. For example, the chip antenna 730 may be located between the first portion 761 and the printed circuit board 750. In an embodiment, the first portion 761 may be referred to as an upper portion, a cover, a cover portion, or a cover member of the conductive member 760. In an embodiment, the second portion 762 may extend from at least a portion of an outer edge of the first portion 761 to the first surface 750A of the printed circuit board 750. The second portion 762 may be coupled to the printed circuit board 750. For example, the second portion 762 may be coupled to the printed circuit board 750 with a fastening member such as e.g., a screw. In an embodiment, the second portion 762 may be referred to as an end portion, a side portion, a side member, a sidewall, a sidewall portion, or a sidewall member of the conductive member 760. The first portion 761 and the second portion 762 may be integrally formed, but the disclosure is not limited thereto. For example, the first portion 761 and the second portion 762 of the conductive member 760 may be configured such that they can be mechanically coupled. In an embodiment, the conductive member 760 may surround the chip antenna 730 to provide electromagnetic shielding for the chip antenna 730. Such a structure makes it possible to reduce influences of other components around the chip antenna 730 on the performance of the chip antenna 730. For example, the conductive member 760 may be referred to as a conductive cover, a conductive structure, or a shield can.

In an embodiment, the conductive member 760 may include an opening 765 (e.g., the opening 265 of FIG. 2B) formed in the first portion 761. The opening 765 may penetrate the first portion 761 so as to be connected to the internal space S1 of the conductive member 760. In an embodiment, the opening 765 of the conductive member 760 may be aligned with the chip antenna 730. For example, the opening 765 of the conductive member 760 may overlap the chip antenna 730. For example, when the first surface 750A of the printed circuit board 750 is viewed from above, the chip antenna 730 may be located within the opening 765. In an embodiment, when the first surface 750A of the printed circuit board 750 is viewed from above, the centers of the opening 765 and the chip antenna 730 may substantially coincide with each other, but the disclosure is not limited thereto. The opening 765 may be referred to as an aperture.

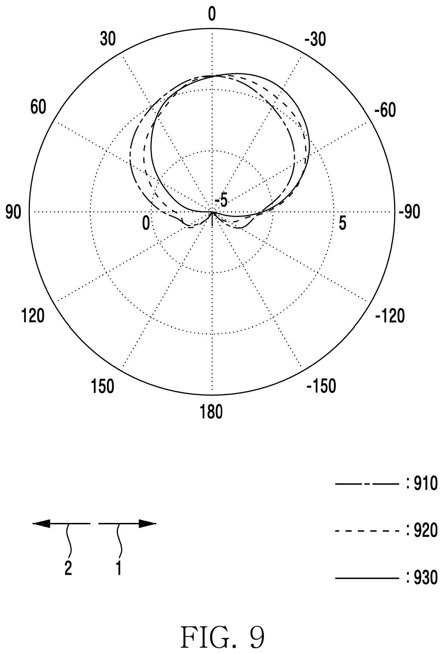

In an embodiment, the opening 765 may be located in a first direction 1 from a center C1 of the first portion 761. For example, the chip antenna 730 may be located in the first direction 1 from the center C1. The center C1 may be a middle point of a length of the second portion 762 based on any one virtual line (e.g., line A-A'), when the second portion 762 is viewed from above. The first direction 1 may be a direction substantially parallel to the first surface 750A of the printed circuit board 750, and a second direction 2 may be a direction opposite to the first direction 1. With this an arrangement, a beam of the chip antenna 730 may be tilted in the first direction 1. It may be because a ground area according to the first direction 1 and a ground area according to the second direction 2 may vary on the basis of the chip antenna 730, depending on relative positions of the chip antenna 730 and the opening 765 with respect to the conductive member 760. For example, as shown in FIGS. 7A and 7B, in a case where the positions of the chip antenna 730 and the opening 765 with respect to the conductive member 760 are biased in the first direction 1, the ground area according to the second direction 2 may be wider than the ground area according to the first direction 1, with respect to the chip antenna 730. Accordingly, the radiation pattern of the chip antenna 730 may be tilted in the first direction 1. Unlike the illustration, in a case where the positions of the chip antenna 730 and the opening 765 with respect to the conductive member 760 are biased in the second direction 2, the radiation pattern of the chip antenna 730 may be tilted in the second direction 2. As such, even if the radiation pattern of the chip antenna 730 is tilted in an unintended direction due to the position of the chip antenna 730 disposed on the printed circuit board 750 and other surrounding components, the radiation pattern of the chip antenna 730 may be adjusted in any intended direction. The radiation pattern of the chip antenna 730 is illustrated in FIG. 9.

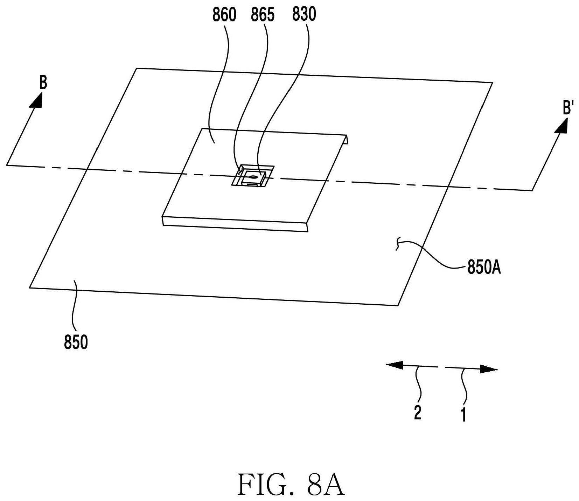

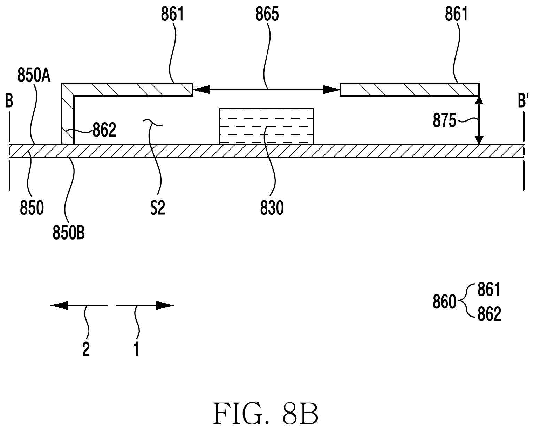

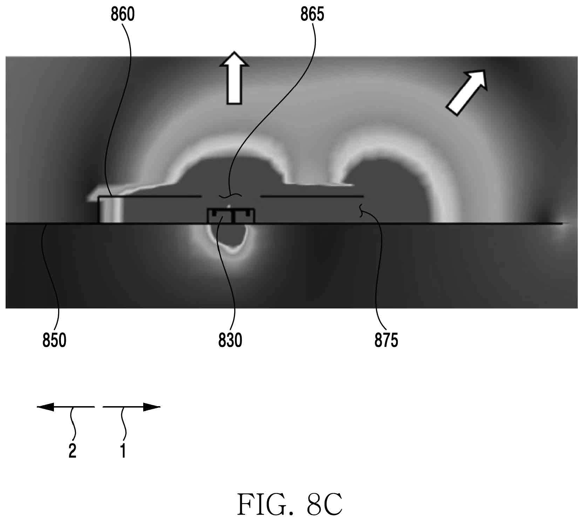

FIGS. 8A and 8B illustrate an example chip antenna disposed on a printed circuit board, according to an embodiment. FIG. 8C illustrates current distribution of a chip antenna disposed on a printed circuit board, according to an embodiment. FIG. 8B may be a cross-sectional view taken along line B-B' of FIG. 8A.

Referring to FIGS. 8A and 8B, an electronic device (e.g., the electronic device 200 of FIG. 2B) according to an embodiment may include a printed circuit board 850, a chip antenna 830, and a conductive member 860 (e.g., the cover plate 260 or a conductive portion of the cover plate 260 of FIG. 2B).

In an embodiment, for the printed circuit board 850, the description provided with reference to the printed circuit board 250 of FIG. 2B and/or the printed circuit board 750 of FIGS. 7A and 7B may be applied in substantially the same way or in a corresponding manner. For example, the printed circuit board 850 may include a first surface 850A (e.g., the first surface 750A) and a second surface 850B (e.g., the second surface 750B) opposite to the first surface 850A.

In an embodiment, for the chip antenna 830, the description provided with reference to the chip antenna 230 of FIG. 2B and/or the chip antenna 730 of FIGS. 7A and 7B may be applied in substantially the same way or in a corresponding manner. For example, the chip antenna 830 may be disposed on the first surface 850A of the printed circuit board 850. The chip antenna 830 may be located inside the conductive member 860.

In an embodiment, for the conductive member 860, the description provided with reference to the conductive member 760 of FIGS. 7A and 7B may be applied in substantially the same way or in a corresponding manner. The redundant description of the conductive member 860 overlapping the description of the conductive member 760 may be omitted.

In an embodiment, the conductive member 860 may be disposed on the first surface 850A of the printed circuit board 850. The conductive member 860 may form an internal space S2 in which the chip antenna 830 is located, together with the first surface 850A of the printed circuit board 850.

In an embodiment, the conductive member 860 may include a first portion 861 (e.g., the first portion 761 of FIG. 7B) and a second portion 862 (e.g., the second portion 762 of FIG. 7B). An opening 865 (e.g., the opening 765 of FIG. 7A) aligned with the chip antenna 830 may be formed in the first portion 861 of the conductive member 860. Although the opening 865 and the chip antenna 830 are illustrated as being located at the center of the conductive member 860, the disclosure is not limited thereto. For example, as described above with reference to FIGS. 7A and 7B, positions of the opening 865 and the chip antenna 830 with respect to the conductive member 860 may be biased in any one direction, for tilting of the radiation pattern of the chip antenna 830. For example, as opposed to the illustration, the positions of the opening 865 and the chip antenna 830 with respect to the conductive member 860 may be biased in a first direction 1, a second direction 2, or a direction different therefrom.

In an embodiment, the conductive member 860 may include an opening 875 (or an aperture) formed by penetrating the second portion 862. The opening 875 may be connected to the internal space S2. The opening 875 may be located in the first direction 1 from the chip antenna 830.

Referring to FIG. 8C, the chip antenna 830 according to an embodiment may radiate through openings 865 and 875 formed in the conductive member 860. By the opening 875 of the conductive member 860 opened in the first direction 1, the radiation pattern of the chip antenna 830 may be tilted in the first direction 1.

FIG. 9 is a view illustrating radiation patterns of a chip antenna. A pattern 910 of FIG. 9 may be a radiation pattern of the chip antenna 730 disposed on the printed circuit board 750, with the conductive member 760 of FIG. 7A omitted. The pattern 910 of FIG. 9 may be a radiation pattern of the chip antenna 830 disposed on the printed circuit board 850 while omitting the conductive member 860 of FIG. 8A. A pattern 920 may be a radiation pattern of the chip antenna 730 surrounded by the conductive member 760 of FIG. 7A. A pattern 930 may be a radiation pattern of the chip antenna 830 surrounded by the conductive member 860 of FIG. 8A.

Referring to the pattern 910 and the pattern 920 of FIG. 9, the radiation pattern of the chip antenna 730 may be tilted in the first direction 1 by the conductive member 760 having the opening 765 aligned with the chip antenna 730 and the positions of the chip antenna 730 and the opening 765. With such a configuration, the radiation pattern of the chip antenna 730 may be adjusted in an intended direction.

Referring to the pattern 910 and the pattern 930 of FIG. 9, the radiation pattern of the chip antenna 830 may be tilted in the first direction 1 by the conductive member 860 having the opening 865 aligned with the chip antenna 830 and the opening 875 located in the first direction 1 of the chip antenna 830. With this configuration, the radiation pattern of the chip antenna 830 may be adjusted in an intended direction.

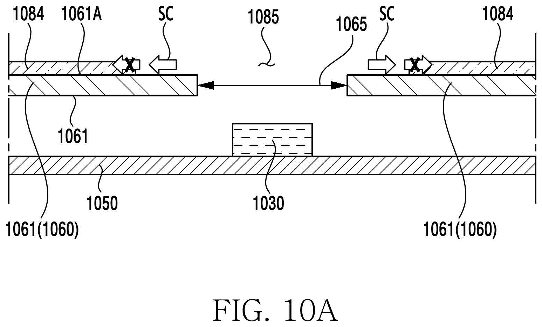

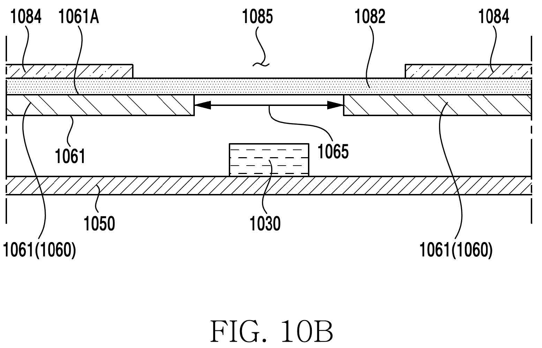

FIGS. 10A, 10B, and 10C are cross-sectional views of an electronic device, according to an embodiment.

Referring to FIG. 10A, an electronic device (e.g., the electronic device 200 of FIG. 2B) according to an embodiment may include a printed circuit board 1050 (e.g., the printed circuit board 750 or 850), a chip antenna 1030 (e.g., the chip antenna 730 or 830) disposed on the printed circuit board 1050, a conductive member 1060 (e.g., the conductive member 760 or 860) disposed on the printed circuit board 1050 so as to cover the chip antenna 1030, and a shielding layer 1084 disposed on the conductive member 1060.

In an embodiment, the conductive member 1060 may include an opening 1065 (e.g., the opening 765 or 865) aligned with the chip antenna 1030.

In an embodiment, the shielding layer 1084 may be disposed on a first portion 1061 (e.g., the first portion 761 or 861) of the conductive member 1060. The shielding layer 1084 may be disposed around the opening 1065 of the conductive member 1060. For example, the shielding layer 1084 may at least partially surround the circumference of the opening 1065 of the conductive member 1060. The shielding layer 1084 may include an opening 1085 aligned with the opening 1065 of the conductive member 1060. The opening 1085 of the shielding layer 1084 may overlap the opening 1065 of the conductive member 1060. The opening 1085 of the shielding layer 1084 may be connected to the opening 1065 of the conductive member 1060. For example, the opening 1085 of the shielding layer 1084 may be formed to have a larger diameter than the opening 1065 of the conductive member 1060, but the disclosure is not limited thereto. In an embodiment, the chip antenna 1030 may be exposed to the outside of the conductive member 1060 through the opening 1065 of the conductive member 1060 and the opening 1085 of the shielding layer 1084.

In an embodiment, the shielding layer 1084 may be formed of materials having relatively high magnetic permeability (e.g., several hundred or more) for blocking electromagnetic waves. For example, the shielding layer 1084 may include a ferrite sheet, but the disclosure is not limited thereto. Due to such a high magnetic permeability of the shielding layer 1084, its intrinsic impedance may be increased. The shielding layer 1084 disposed on the conductive member 1060 may block a surface current SC flowing through the conductive member 1060. Accordingly, during operation of the chip antenna 1030, a surface current flowing in a horizontal direction along the surface of the conductive member 1060 may be blocked. Accordingly, it is possible to reduce or prevent tilting of the radiation pattern of the chip antenna 1030 due to the position of the chip antenna 1030 disposed on the printed circuit board 1050 and/or other components around the chip antenna 1030. Since the radiation pattern may be tilted due to the asymmetric current flowing to the ground, the beam tilting of the chip antenna 1030 may be reduced or prevented by blocking such surface current with the shielding layer 1084.

Referring to FIG. 10B, according to an embodiment, the electronic device may further include a non-metallic layer 1082 interposed between the shielding layer 1084 and the conductive member 1060. In an embodiment, the non-metallic layer 1082 may include a section overlapping the opening 1065 of the conductive member 1060 and the opening 1085 of the shielding layer 1084. For example, the section of the non-metallic layer 1082 may be located between the opening 1065 of the conductive member 1060 and the opening 1085 of the shielding layer 1084. In an embodiment, the opening 1065 of the conductive member 1060 may be closed by the non-metallic layer 1082. The chip antenna 1030 may be hidden by the non-metallic layer 1082 covering the opening 1065 of the conductive member 1060. In an embodiment, the non-metallic layer 1082 may be formed of an electrically non-conductive material. For example, the non-metallic layer 1082 may include graphite and/or polyimide, but the disclosure is not limited thereto.

Referring to FIG. 10C, according to an embodiment, the electronic device may further include an antenna pattern 1086 disposed on the shielding layer 1084. The antenna pattern 1086 may be formed of a conductive material (e.g., copper). In an embodiment, the antenna pattern 1086 may include a coil-shaped conductive pattern. For example, it may include an NFC antenna.

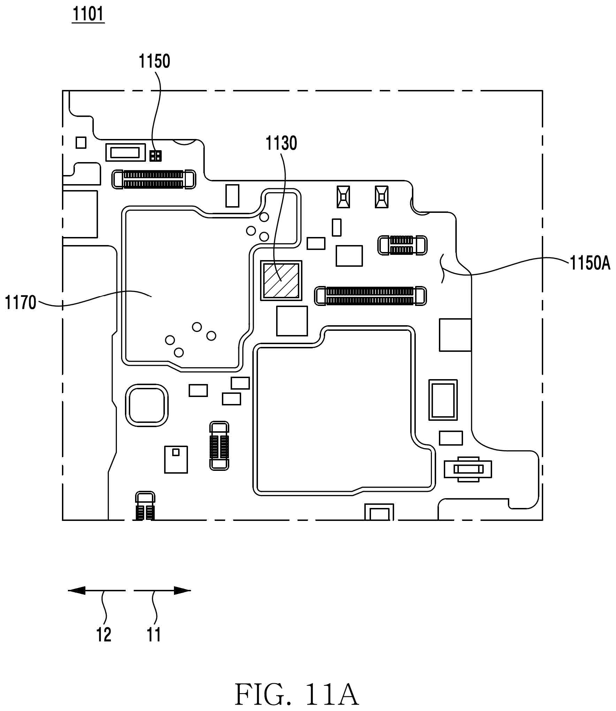

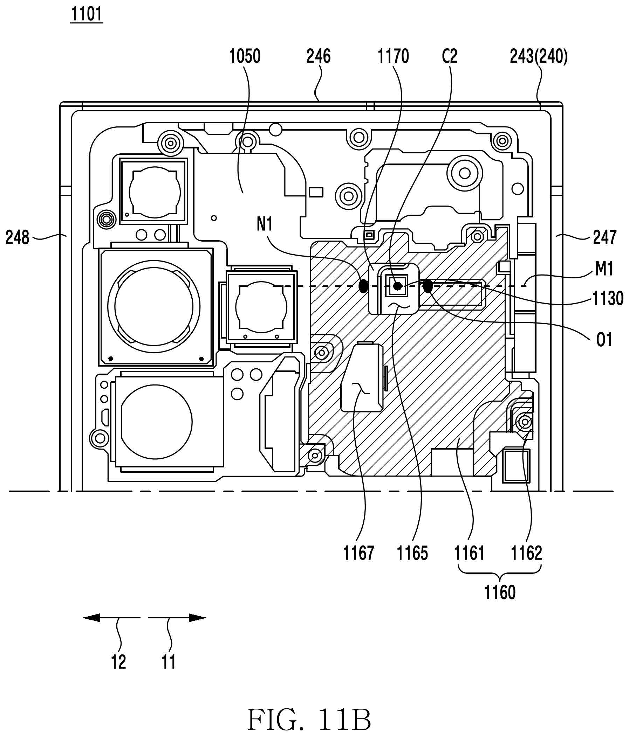

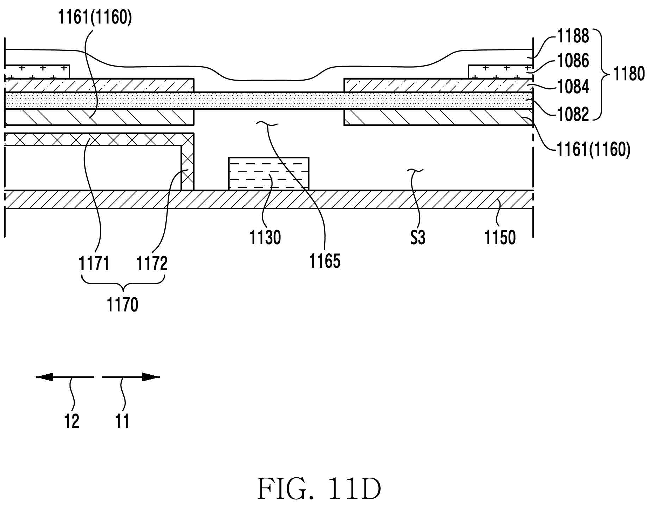

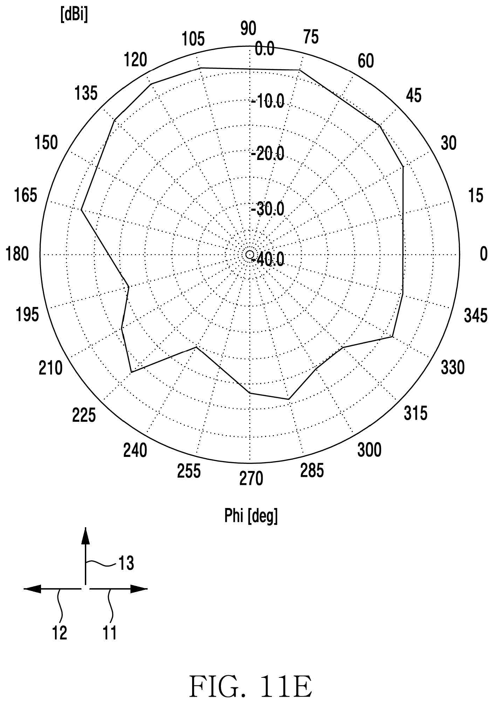

FIG. 11A illustrates an example printed circuit board on which a chip antenna is disposed, according to an embodiment. FIG. 11B illustrates an example electronic device including a printed circuit board on which a conductive member is disposed, according to an embodiment. FIG. 11C illustrates an example electronic device including an antenna module disposed on a conductive member. FIG. 11D is a cross-sectional view taken along line C-C' of FIG. 11C. FIG. 11E illustrates a radiation pattern of a chip antenna, according to an embodiment.

Referring to FIG. 11A, an electronic device 1101 (e.g., the electronic device 200 of FIG. 2B) according to an embodiment may include a printed circuit board 1150 (e.g., the printed circuit board 750, 850, or 1050), a chip antenna 1130 (e.g., the chip antenna 730, 830, or 1030) disposed on the printed circuit board 1150, and a shield can 1170.

In an embodiment, the shield can 1170 may be disposed on the printed circuit board 1150. For example, the shield can 1170 may be disposed on a surface (e.g., the first surface 850A of FIG. 8B) among surfaces of the printed circuit board 1150 where the chip antenna 1130 is disposed. The shield can 1170 may be located adjacent to the chip antenna 1130.

Referring to FIG. 11B, the electronic device 1101 according to an embodiment may include a conductive member 1160 (e.g., the conductive member 760, 860, or 1060) disposed to cover at least a portion of the chip antenna 1130 and the printed circuit board 1150. An opening 1165 (e.g., the opening 765, 865, or 1065) aligned with the chip antenna 1130 may be formed in the conductive member 1160. The opening 1165 may overlap the chip antenna 1130. In FIG. 11B, a portion of the shield can 1170 is illustrated as being located within the opening 1165, but the disclosure is not limited thereto. For example, the shield can 1170 may not overlap the opening 1165, or a boundary of the shield can 1170 may coincide with a boundary of the opening 1165.

In an embodiment, another opening 1167 may be formed in the conductive member 1160. Although not shown herein, a connection member such as a cable or a flexible printed circuit board (FPCB) may pass through the other opening 1167 of the conductive member 1160 and be connected to the printed circuit board 1150.

In an embodiment, the second part 243 of the frame structure 240 may include a first side 246, a second side 247, and/or a third side 248. The first side 246 may extend along a first direction 11. The second side 247 may extend from a first end, facing the first direction 11, of both ends of the first side 246. The second side 247 may be substantially perpendicular to the first side 246, but the disclosure is not limited thereto. The third side 248 may extend from a second end, facing a second direction 12 opposite to the first direction 11, of both ends of the first side 246. The third side 248 may be substantially perpendicular to the first side 246, but the disclosure is not limited thereto. In a non-limiting embodiment, the length of the first side 246 may be smaller than the length of the second side 247 and/or the third side 248, but the disclosure is not limited thereto. In this regard, the first side 246 may be referred to as a short side, the second side 247 may be referred to as a first long side, and the third side 248 may be referred to as a second long side. In an embodiment, the first direction 11 may be a direction substantially parallel to the first direction 1 of FIG. 7A, 7B, 8A, 8B, 8C, or 9, but the disclosure is not limited thereto. In an embodiment, the second direction 12 may be a direction substantially parallel to the second direction 2 of FIG. 7A, 7B, 8A, 8B, 8C, or 9, but the disclosure is not limited thereto.

In an embodiment, a virtual line M1 passing through a center C2 of the chip antenna 1130 may be defined. The virtual line M1 may be parallel to the first direction 11 or the second direction 12, but the disclosure is not limited thereto. Further, although not shown, a center N1 of the printed circuit board 1150 based on the virtual line M1 may be defined. The center N1 of the printed circuit board 1150 may be a middle point of a length of the printed circuit board 1150 based on the virtual line M1. Further, a center O1 of the conductive member 1160 (or the first portion 1161) based on the virtual line M1 may be defined. The center O1 of the conductive member 1160 may be a middle point of a length of the first portion 1161 based on the virtual line M1.

The center C2 of the chip antenna 1130 may be located in the first direction 11 from the center N1 of the printed circuit board 1150. As the chip antenna 1130 is asymmetrically located with respect to the ground of the printed circuit board 1150, the radiation pattern of the chip antenna 1130 may be tilted differently than intended. For example, the radiation pattern of the chip antenna 1130 may be tilted in the first direction 11. For example, the opening 1165 may be located in the second direction 12 from the center O1 of the conductive member 1160. Accordingly, the radiation pattern of the chip antenna 1130 aligned with the opening 1165 can be adjusted in any intended direction. For example, the radiation pattern of the chip antenna 1130 may be tilted in the second direction 12.

As described above, FIG. 11B illustrates a case where the opening 1165 and the chip antenna 1130 are biased in the second direction 12 with respect to the conductive member 1160, but the disclosure is not limited thereto. For adjusting the tilting of the radiation pattern of the chip antenna 1130, the method described with reference to FIGS. 7A and 7B or the method described with reference to FIGS. 8A to 8C may be applied. For adjusting the beam pattern in any intended direction, the printed circuit board 1150, the chip antenna 1130, the conductive member 1160, and the opening 1165 of the conductive member 1160 may have positional relationships different from that of the illustrated example.

Referring to FIGS. 11C and 11D, according to an embodiment, the electronic device 1101 may include a cover layer 1180 disposed on the conductive member 1160. In an embodiment, the cover layer 1180 may include one or more layers. For example, as shown in FIG. 10A, the cover layer 1180 may include a shielding layer 1084. As another example, as shown in FIG. 10B, the cover layer 1180 may include a non-metallic layer 1082 and the shielding layer 1084. As another example, as shown in FIG. 10C, the cover layer 1180 may include the non-metallic layer 1082, the shielding layer 1084, and an antenna pattern 1086. As another example, as shown in FIGS. 11C and 11D, the cover layer 1180 may include the non-metallic layer 1082, the shielding layer 1084, the antenna pattern 1086, and a protective layer 1188 covering these elements. The protective layer 1188 may at least partially cover the non-metallic layer 1082, the shielding layer 1084, and the antenna pattern 1086. The protective layer 1188 may include a material capable of absorbing shock, such as e.g., a sponge.

Referring to FIG. 11D, the shield can 1170 may be located within an internal space S3 (e.g., the internal space S1 or S2) of the conductive member 1160. In an embodiment, the shield can 1170 may include a cover 1171 facing the first portion 1161 of the conductive member 1160 and a sidewall 1172 facing the chip antenna 1130. The cover 1171 may extend from an upper end of the sidewall 1172. In an embodiment, the radiation pattern of the chip antenna 1130 may be tilted due to the shield can 1170. For example, the shield can 1170 may block the internal space S3 (or a path leading to one direction of the opening 1165) in the second direction 12 of the chip antenna 1130, and thus the radiation pattern of the chip antenna 1130 may be tilted in the first direction 11.

In an embodiment, the shielding layer 1084 may be disposed on the conductive member 1160 (or the non-metallic layer 1082) such that it surrounds at least a portion of the opening 1165, and thus unintended tilting of the radiation pattern of the chip antenna 1130 may be reduced or prevented. For example, as shown in FIG. 11E, a radiation pattern facing a third direction 13 (e.g., the -Z direction of FIG. 2B) perpendicular to the first direction 11 and the second direction 12 may be formed without being biased toward the first direction 11 or the second direction 12.

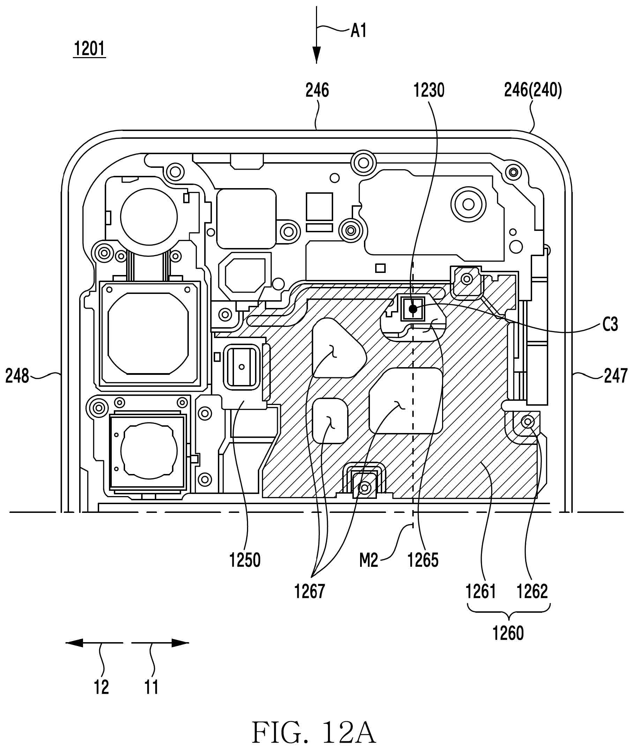

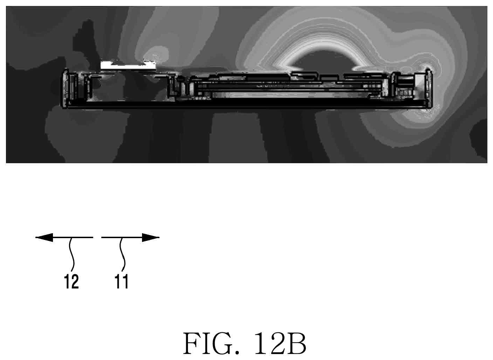

FIG. 12A illustrates an example electronic device including a printed circuit board on which a conductive member is disposed, according to an embodiment. FIG. 12B illustrates current distribution of an electronic device, according to an embodiment. FIG. 12B may be current distribution in a case where an electronic device 1201 of FIG. 12A is viewed in a direction A1.

Referring to FIG. 12A, an electronic device 1201 (e.g., the electronic device 200 of FIG. 2B) according to an embodiment may include a printed circuit board 1250 (e.g., the printed circuit board 750, 850, 1050, or 1150), a chip antenna 1230 (e.g., the chip antenna 730, 830, 1030, or 1130) disposed on the printed circuit board 1250, and a conductive member 1260 (e.g., the conductive member 760, 860, 1060, or 1160) disposed to overlap at least a portion of the printed circuit board 1250 so as to cover the chip antenna 1230.

In an embodiment, an opening 1265 (e.g., the opening 765, 865, 1065, or 1165) aligned with the chip antenna 1230 may be formed in the conductive member 1260. The opening 1265 may overlap the chip antenna 1230. In an embodiment, a plurality of openings 1267 may be formed in the conductive member 1260. A size of each of the plurality of openings 1267 may be, for example, substantially the same as or larger than the opening 1265. For example, the size (e.g., width or height) of each of the plurality of openings 1267 may be greater than or equal to a wavelength (λ)/10. The wavelength may be a wavelength of a signal to be transmitted and received using the chip antenna 1230.

Although not shown herein, a cover layer (e.g., the cover layer 1180 of FIG. 11D) may be disposed on the conductive member 1260 additionally or optionally.

In an embodiment, a virtual line M2 passing through a center C3 of the chip antenna 1230 may be defined. The virtual line M2 may be perpendicular to the first direction 11 and the second direction 12, but the disclosure is not limited thereto. Although not shown, a first portion 1261 of the conductive member 1260 may include a first area and a second area divided based on the virtual line M2. For example, the first area of the conductive member 1260 may be an area of the first portion 1261 located in the first direction 11 based on the virtual line M2. For example, the second area of the conductive member 1260 may be an area of the first portion 1261 located in the second direction 12 based on the virtual line M2. In an embodiment, areas of the first area and the second area may be different from each other. A surface current flowing to the conductive member 1260 through the opening 1265 may flow differently through the first area and the second area. Due to the asymmetry of the surface current, the radiation pattern of the chip antenna 1230 may be tilted. According to an embodiment, to prevent this phenomenon, a plurality of openings 1267 penetrating the first portion 1261 may be formed. The plurality of openings 1267 may make the current flow irregular by disturbing the current flowing through the conductive member 1260. Accordingly, it is possible to reduce or prevent the radiation pattern of the chip antenna 1230 from being tilted in a specific direction. For example, the second area may have a larger area than the first area, and thus the radiation pattern of the chip antenna 1230 may be tilted in the first direction 11 due to the resulting asymmetric surface current. The plurality of openings 1267 may be formed more in the second area among the first area and the second area. For example, centers of each of the plurality of openings 1267 may be located in the second area. Accordingly, it is possible to reduce or prevent the radiation pattern of the chip antenna 1230 from being tilted in the first direction 11. For example, as shown in FIG. 12B, a current distribution that is not biased either in the first direction 11 or in the second direction 12 may be formed. Furthermore, due to the plurality of openings 1267, the weight of the conductive member 1260 may be reduced and its weight balance may be further improved.

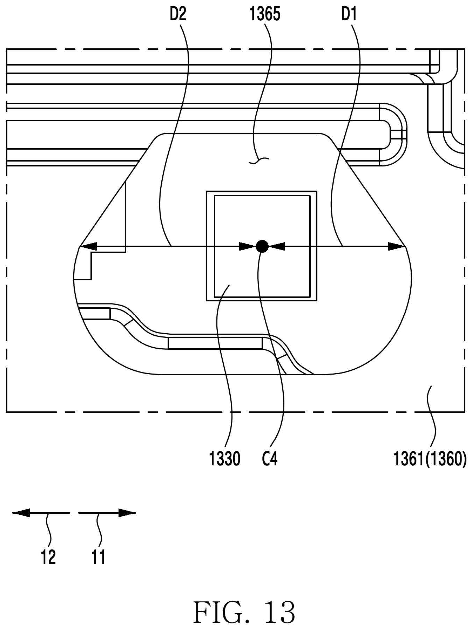

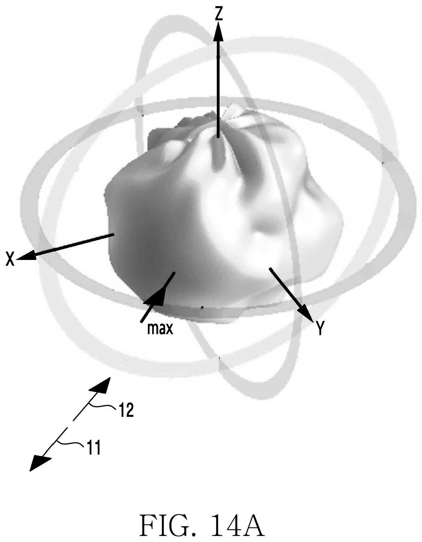

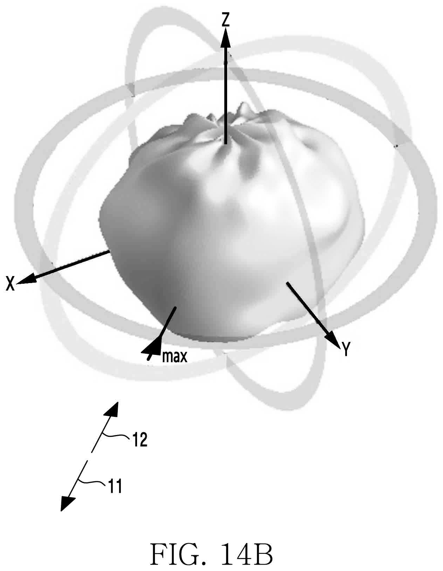

FIG. 13 is a view illustrating an alignment relationship between a chip antenna and an opening of a conductive member, according to an embodiment. FIG. 14A illustrates a radiation pattern in a case where a chip antenna is offset-aligned with respect to an opening, according to an embodiment. FIG. 14B illustrates a radiation pattern in a case where a chip antenna is aligned with a center of an opening, according to an embodiment.

Referring to FIG. 13, a chip antenna 1330 may be offset-aligned with respect to an opening 1365. For example, a center C4 of the chip antenna 1330 may not coincide with a center of the opening 1365 formed in a first portion 1361 of a conductive member 1360. For example, on the basis of one direction (e.g., the first direction 11), a distance from the center C4 of the chip antenna 1330 to a boundary of the opening 1365 may be a first distance D1. On the basis of a direction opposite to the one direction (e.g., the second direction 12), a distance from the center C4 of the chip antenna 1330 to the boundary of the opening 1365 may be a second distance D2. The first distance D1 and the second distance D2 may be different from each other. For example, the first distance D1 may be less than the second distance D2. As the chip antenna 1330 is offset with respect to the opening 1365, a radiation pattern of the chip antenna 1330 may be tilted. For example, as illustrated, in a case where the chip antenna 1330 is offset in the first direction 11 with respect to the opening 1365, the radiation pattern of the chip antenna 1330 may be tilted in the first direction 11. For example, the radiation pattern of FIG. 14A may be a radiation pattern in a case where the chip antenna 1330 of FIG. 13 is offset in the first direction 11 with respect to the opening 1365. The radiation pattern of FIG. 14B may be a radiation pattern in a case where the chip antenna 1330 is aligned with the center of the opening 1365 without being offset. The radiation pattern of FIG. 14A may be tilted more in the first direction 11 than the radiation pattern of FIG. 14B.

The above description for the conductive member 1360, the opening 1365, and the chip antenna 1330 of FIG. 13 may be also applied in substantially the same manner to the conductive member 760, 860, 1060, 1160, or 1260, the opening 765, 865, 1065, 1165, or 1265, and the chip antenna 730, 830, 1030, 1130, or 1230 as described above.

The above description for the conductive member 1360, the opening 1365, and the chip antenna 1330 of FIG. 13 may be also applied in substantially the same manner to a conductive member 1560, an opening 1665, and a chip antenna 1630 to be described later.

The aforementioned description for the alignment relationship between the opening 1365 and the chip antenna 1330 of FIG. 13 may be also applied in substantially the same manner to the alignment relationship between the opening 1665 and the chip antenna 1630 to be described later.

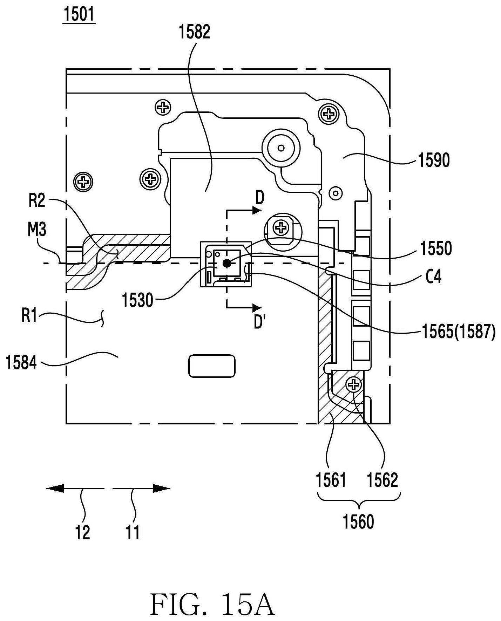

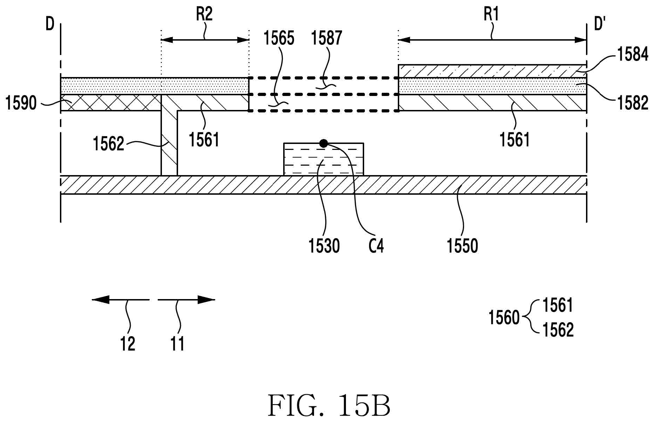

FIG. 15A is an exemplary view illustrating an electronic device, according to an embodiment. FIG. 15B is a cross-sectional view taken along line D-D' of FIG. 15A.

Referring to FIGS. 15A and 15B, an electronic device 1501 (e.g., the electronic device 200 of FIG. 2B) according to an embodiment may include a printed circuit board 1550 (e.g., the printed circuit board 750, 850, 1050, 1150, or 1250), a chip antenna 1530 (e.g., the chip antenna 730, 830, 1030, 1130, or 1230) disposed on the printed circuit board 1550, and a conductive member 1560 (e.g., the conductive member 760, 860, 1060, 1160, or 1260) disposed to cover the chip antenna 1530. In an embodiment, the conductive member 1560 may include a first portion 1561 (e.g., the first portion 761, 861, 1061, 1161, or 1261) and a second portion 1562 (e.g., the second portion 762, 862, or 1262). In an embodiment, an opening 1565 (e.g., the opening 765, 865, 1065, 1165, or 1265) may be formed in the first portion 1561 of the conductive member 1560.

In an embodiment, the electronic device 1501 may further include a non-conductive member 1590, a non-metallic layer 1582 (e.g., the non-metallic layer 1082 of FIG. 10B), and a shielding layer 1584 (e.g., the shielding layer 1084 of FIG. 10B).

In an embodiment, the non-conductive member 1590 may be disposed to overlap at least a portion of the printed circuit board 1550. For example, the non-conductive member 1590 may cover some of components disposed on the printed circuit board 1550. For example, the non-conductive member 1590 may be coupled to the conductive member 1560.

In an embodiment, a non-metallic layer 1582 may be disposed on the non-conductive member 1590 and the conductive member 1560. Unlike the non-metallic layer 1082 of FIG. 10B, the non-metallic layer 1582 may include a through hole 1587 connected to the opening 1565.

In an embodiment, the shielding layer 1584 may surround only a portion of the periphery of the opening 1565. In an embodiment, the shielding layer 1584 may be disposed on a partial area of the non-conductive member 1590 (or the first portion 1561). For example, the first portion 1561 of the conductive member 1560 (or a section of the non-metallic layer 1582 disposed on the first portion 1561) may include a first area R1 and a second area R2. The first area R1 and the second area R2 may be areas divided based on a virtual line M3 passing through the center C4 of the chip antenna 1530. For example, the virtual line M3 dividing the first area R1 and the second area R2 may pass through the center C4 of the chip antenna 1530 and be parallel to the first direction 11, but the disclosure is not limited thereto. In an embodiment, the areas of the first area R1 and the second area R2 may be different from each other. For example, the area of the first area R1 may be greater than the area of the second area R2. In an embodiment, an area of the shielding layer 1584 formed on the first area R1 may be greater than an area of the shielding layer 1584 formed on the second area R2. As the area of the first area R1 and the area of the second area R2 of the conductive member 1560 are different, a surface current of the chip antenna 1530 may flow asymmetrically through the conductive member 1560, and the radiation pattern of the chip antenna 1530 may be tilted unintendedly. The first area R1, which has a larger area than the second area R2 of the conductive member 1560, may have a greater influence on the tilting of the radiation pattern of the chip antenna 1530. By forming the area where the shielding layer 1584 is disposed to be wider in the first area R1 than in the second area R2, it is possible to reduce or prevent unintended tilting of the radiation pattern of the chip antenna 1530 caused by the conductive member 1560.

Unlike the illustration of FIG. 15B, the non-metallic layer 1582 may be omitted, and the shielding layer 1584 may be disposed on the conductive member 1560. Additionally, an antenna pattern (e.g., the antenna pattern 1086 of FIG. 11D) and/or a protective layer (e.g., the protective layer 1188 of FIG. 11D) may be disposed on the shielding layer 1584.

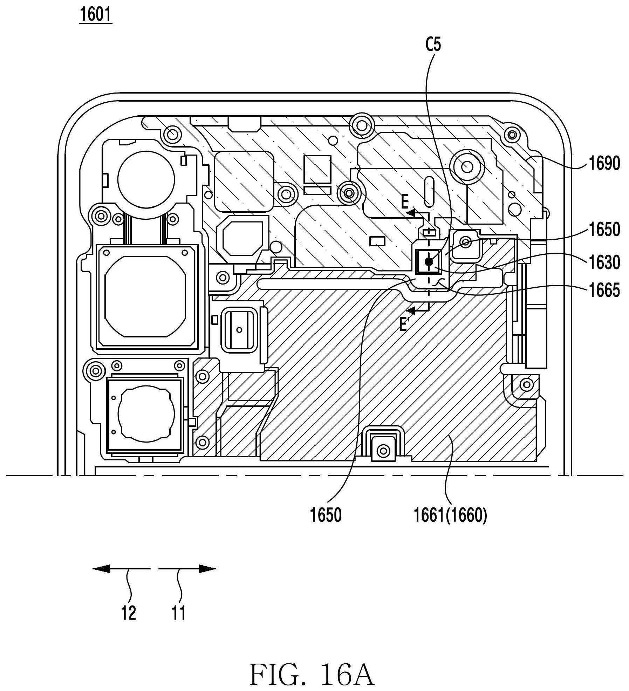

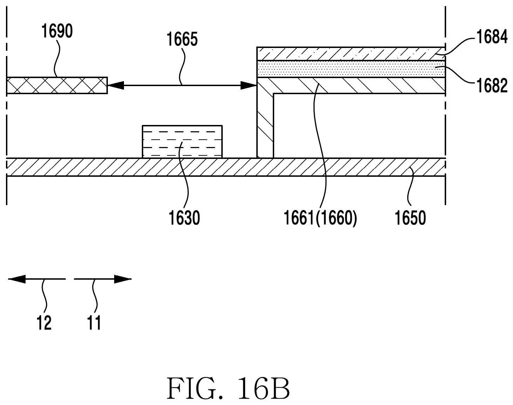

FIG. 16A is an exemplary view illustrating an electronic device, according to an embodiment. FIG. 16B is a cross-sectional view taken along line E-E' of FIG. 16A.

Referring to FIGS. 16A and 16B, an electronic device 1601 (e.g., the electronic device 200 of FIG. 2B) according to an embodiment may include a printed circuit board 1650 (e.g., the printed circuit board 750, 850, 1050, 1150, 1250, or 1550), and a chip antenna 1630 (e.g., the chip antenna 730, 830, 1030, 1130, 1230, or 1530) disposed on the printed circuit board 1650.

According to an embodiment, the electronic device 1601 may include a conductive member 1660 and a non-conductive member 1690 (e.g., the non-conductive member 1590 of FIG. 15A). Unlike the aforementioned openings 765, 865, 1065, 1165, 1265, and 1565 being formed in the conductive members 760, 860, 1060, 1160, 1260, and 1560, an opening 1665 of the electronic device 1601 may be formed by the conductive member 1660 and the non-conductive member 1690. For example, the opening 1665 may be formed by a gap between the conductive member 1660 and the non-conductive member 1690. The chip antenna 1630 may be disposed on the printed circuit board 1650 so as to be aligned with the opening 1665. The chip antenna 1630 may be located between the non-conductive member 1690 and the conductive member 1660.

According to an embodiment, the electronic device 1601 may include a non-metallic layer 1682 (e.g., the non-metallic layer 1082 or 1582) and a shielding layer 1684 (e.g., the shielding layer 1084 or 1584). The non-metallic layer 1682 may be disposed on a first portion 1661 of the conductive member 1660. The shielding layer 1684 may be disposed on the non-metallic layer 1682. For example, the shielding layer 1684 may surround at least a portion of the periphery of the opening 1665. A surface current of the chip antenna 1630 may flow through the conductive member 1660, and therefore, the radiation pattern of the chip antenna 1630 may be tilted unintendedly. Such unintended tilting of the radiation pattern may be reduced or prevented by the shielding layer 1684 located on the conductive member 1660.

Unlike the illustration of FIG. 16B, the non-metallic layer 1682 may be omitted, and the shielding layer 1684 may be disposed on the conductive member 1660. Additionally, an antenna pattern (e.g., the antenna pattern 1086 of FIG. 11D) and/or a protective layer (e.g., the protective layer 1188 of FIG. 11D) may be disposed on the shielding layer 1684.

Although not shown herein, the non-conductive member 1690 may further include a portion extending to the printed circuit board 1650 to face the chip antenna 1630.

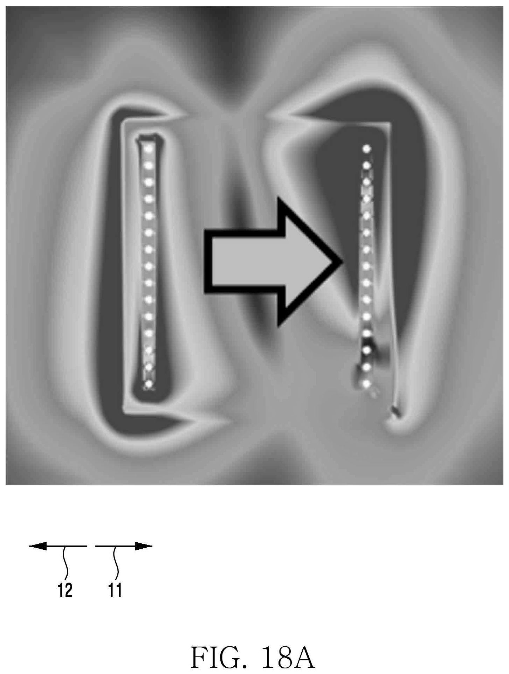

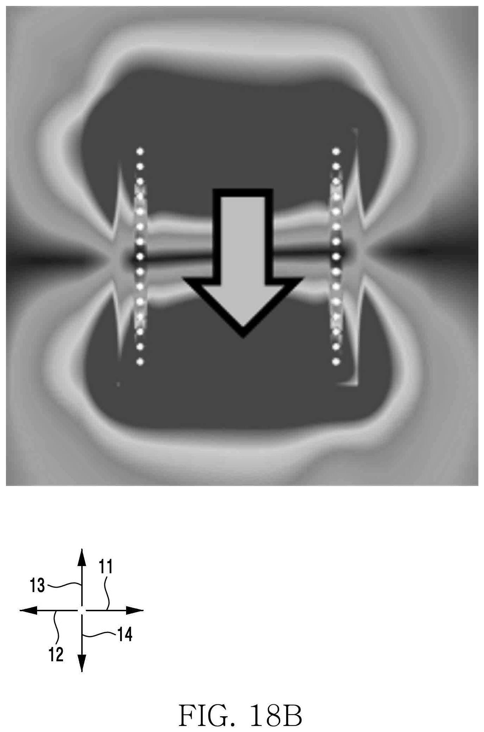

FIG. 17 is a view illustrating a chip antenna according to an embodiment. FIG. 18A illustrates current distribution in a chip antenna forming a first polarization according to an embodiment. FIG. 18B illustrates current distribution in a chip antenna forming a second polarization according to an embodiment. The description of a chip antenna 1730 to be described later may be also applied in substantially the same manner to the aforementioned chip antennas 230, 730, 830, 1030, 1130, 1230, 1530, and 1630.

Referring to FIG. 17, a chip antenna 1730 according to an embodiment may include a plurality of layers formed of ceramic. The chip antenna 1730 may include a first patch 1720, a feeding pad 1710, a ground pad 1740, and a signal line 1750 that are formed inside the plurality of layers. The ground pad 1740 may surround the feeding pad 1710. The signal line 1750 may extend from the feeding pad 1710 toward the first patch 1720 to transfer an electrical signal transferred through the feeding pad 1710 to the first patch 1720. A position of the first patch 1720, to which power is fed via the feeding pad 1710 and the signal line 1750, may be offset from a center of the first patch 1720, but the disclosure is not limited thereto. In an embodiment, the signal line 1750 may include a conductive via.

In an embodiment, a first surface 1730A of the chip antenna 1730 on which the feeding pad 1710 and the ground pad 1740 are formed may be disposed on a printed circuit board (e.g., the printed circuit boards 250, 750, 850, 1050, 1150, 1250, 1550, and 1650). The feeding pad 1710 may be electrically connected to a wireless communication circuit (e.g., the wireless communication module 192 of FIG. 1) of the electronic device. The ground pad 1740 may be electrically connected to the ground of the printed circuit board. The first patch 1720 may be located on or under a second surface 1730B opposite to the first surface 1730A of the chip antenna 1730. Alternatively or optionally, the chip antenna 1730 may not include the ground pad 1740.

In an embodiment, the first patch 1720 may have a rectangular shape having short sides and long sides. In an embodiment, the first patch 1720 may form a first resonance frequency corresponding to the long sides and a second resonance frequency corresponding to the short sides, the second resonance frequency being higher than the first resonance frequency. The first resonance frequency may support, for example, UWB Channel 5 having a center frequency of 6489.6 MHz and a bandwidth of 499.2 MHz. The second resonance frequency may support, for example, UWB Channel 9 having a center frequency of 7987.2 MHz and a bandwidth of 499.2 MHz.

Additionally, the chip antenna 1730 may include a second patch 1722 and/or a third patch 1724. The second patch 1722 may be located below a first short side among the short sides of the first patch 1720. The second patch 1722 may include one or more conductive patches in one or more layers. The chip antenna 1730 may include one or more conductive vias for connecting the first patch 1720 and the second patch 1722. The third patch 1724 may be located below a second short side among the short sides of the first patch 1720. The third patch 1724 may include one or more conductive patches in one or more layers. The chip antenna 1730 may include one or more conductive vias for connecting the first patch 1720 and the third patch 1724. Due to the second patch 1722 and the third patch 1724, a length for forming a resonance frequency of the chip antenna 1730 may be increased. In an embodiment, the first patch 1720, the second patch 1722, the third patch 1724, the feeding pad 1710, the ground pad 1740, and the signal line 1750 may be formed of a conductive material (e.g., copper).

Referring to FIG. 18A, a strong current (or electric field) may be formed along the long sides of the first patch 1720, and the current may flow in a direction from the center of the first patch 1720 toward the long sides (e.g., the first direction 11 or the second direction 12 opposite thereto). Accordingly, a signal having a first polarization may be radiated by the first patch 1720. Referring to FIG. 18B, a strong current may be formed along the short sides of the first patch 1720, and current may flow in a direction from the center of the first patch 1720 toward the short sides (e.g., the third direction 13 perpendicular to the first direction 11 or the fourth direction 14 opposite to the third direction 13). The current flow through the first patch 1720 in FIG. 18B may be substantially perpendicular to the current flow through the first patch 1720 in FIG. 18A. As such, a signal having a second polarization perpendicular to the first polarization may be radiated by the first patch 1720.

In a comparative example, an FPCB antenna including a plurality of conductive patches may be used as an alternative to the chip antenna 1730. However, the chip antenna 1730 may have a smaller area and a lower price than the FPCB antenna. The chip antenna 1730 may have greater thickness than the FPCB antenna, but since there may exist any components higher in height than the chip antenna 1730 among other components disposed on the printed circuit board 1730, the influence due to the height of the chip antenna 1730 may not be significant.

According to an embodiment, an electronic device (e.g., the electronic device 101, 200, 1101, 1201, 1501, or 1601) may include a printed circuit board (e.g., the printed circuit board 250, 750, 850, 1050, 1150, 1250, 1550, or 1650), a chip antenna (e.g., the chip antenna 230, 730, 830, 1030, 1130, 1230, 1530, or 1630) disposed on the printed circuit board, a conductive member (e.g., the conductive member 760, 860, 1060, 1160, 1260, 1560, or 1660) disposed on the printed circuit board and including a cover portion (e.g., the first portion 761, 861, 1061, 1161, 1261, 1561, or 1661) positioned over the chip antenna, the cover portion including a first opening (e.g., the first opening 265, 765, 865, 1065, 1165, 1265, 1565, or 1665) aligned with the chip antenna, a non-metallic layer (e.g., the non-metallic layer 1082, 1582, or 1682) disposed on the cover portion to close the first opening, and a shielding layer (e.g., the shielding layer 1084, 1584, or 1684) disposed on the non-metallic layer. The shielding layer may include a second opening (e.g., the opening 1085) aligned with the first opening of the cover portion.

In an embodiment, the cover portion of the conductive member may include a first area (e.g., the first area R1 of FIG. 15A) and a second area (e.g., the second area R2 of FIG. 15A) divided based on a virtual line passing through a center of the chip antenna. A size of the first area may be larger than a size of the second area. A size of a first section of the shielding layer disposed on at least a portion of the first area may be larger than a size of a second section of the shielding layer disposed on at least a portion of the second area.

In an embodiment, the printed circuit board may include a center based on the virtual line. The center of the chip antenna may be located in a first direction from the center of the printed circuit board.

In an embodiment, a center of the first opening may be located in the first direction or a second direction opposite to the first direction from a center of the cover portion.

In an embodiment, the center of the chip antenna may be substantially coincident with the center of the first opening.

In an embodiment, the center of the chip antenna may be closer to the center of the printed circuit board than the center of the first opening.

In an embodiment, the center of the chip antenna may be farther from the center of the printed circuit board than the center of the first opening.

In an embodiment, the electronic device may include a housing (e.g., the frame structure 240 of FIG. 11B) in which the printed circuit board is disposed. Sides of the housing may include a long side (e.g., the second side 247 or the third side 248 of FIG. 11B) and a short side (e.g., the first side 246 of FIG. 11B) connected to the long side. The first direction may be a direction substantially parallel to the short side.

In an embodiment, the cover portion of the conductive member may include a plurality of openings (e.g., a plurality of openings 1267 of FIG. 12A). A center of each of the plurality of openings may be located in a second direction, which is an opposite direction to the first direction, from the center of the chip antenna.

In an embodiment, the center of each of the plurality of openings may be located on the first area of the cover portion.

In an embodiment, the non-metallic layer may include sections overlapping the plurality of openings. The shielding layer may include sections overlapping on the sections of the non-metallic layer.

In an embodiment, the electronic device may include a shield can (e.g., the shield can 1170 of FIG. 11A) disposed on the printed circuit board. The cover portion of the conductive member may be located on the shield can.

In an embodiment, the shield can may include a sidewall (e.g., the sidewall 1172 of FIG. 11D) facing a side of the chip antenna.

In an embodiment, the electronic device may include an antenna pattern (e.g., the antenna pattern 1086 of FIG. 10C) disposed on the shielding layer.

In an embodiment, the electronic device may include a protective layer (e.g., the protective layer 1188 of FIG. 11D) disposed on the antenna pattern. The protective layer may include a section overlapping the second opening of the shielding layer.

In an embodiment, the chip antenna may include a first conductive patch (e.g., the first patch 1720 of FIG. 17), a feeding pad (e.g., the feeding pad 1710 of FIG. 17) spaced apart from the first conductive patch and contacting the printed circuit board, a signal line (e.g., the signal line 1750 of FIG. 17) extending from the feeding pad toward the first conductive patch, and a ground pad (e.g., the ground pad 1740 of FIG. 17) contacting the printed circuit board.

In an embodiment, the first conductive patch may have a rectangular shape including short sides and long sides. The chip antenna may include a second conductive patch (e.g., the second patch 1722 of FIG. 17) positioned between the first conductive patch and the ground pad to be aligned with a first short side of the first conductive patch, a first conductive via electrically connecting the first short side of the first conductive patch and the second conductive patch, a third conductive patch (e.g., the third patch 1724 of FIG. 17) positioned between the first conductive patch and the ground pad to be aligned with a second short side of the first conductive patch, and a second conductive via electrically connecting the second short side of the first conductive patch and the third conductive patch.

In an embodiment, the signal line may include a conductive via.

In an embodiment, the electronic device may include a wireless communication circuit (e.g., the wireless communication module 192 of FIG. 1). The wireless communication circuit may be configured to transmit or receive an ultra-wideband (UWB) signal using the chip antenna.

In an embodiment, the shielding layer may include a ferrite sheet.

The conductive member may include a portion (e.g., the second portion 762, 862, 1262, or 1562) extending from the cover portion to the printed circuit board and coupled to the printed circuit board.

In an embodiment, the conductive member may include a sidewall (e.g., the second portion 762, 862, 1262, or 1562) extending from an outer edge of the cover portion to the printed circuit board. An aperture (e.g., the opening 875 of FIG. 8B) may be formed in a portion of the sidewall. The aperture may be located in the first direction from the chip antenna.

In an embodiment, the shielding layer may not be disposed on the second area of the cover portion.

The electronic device according to various embodiments disclosed herein may be one of various types of electronic devices. The electronic devices may include, for example, a portable communication device (e.g., a smartphone), a computer device, a portable multimedia device, a portable medical device, a camera, a wearable device, or a home appliance. In an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect e.g., importance or order. In a case where an element (e.g., a first element) is referred to, with or without the term "operatively" or "communicatively", as "coupled" or "connected" to/with another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may be interchangeably used with other terms, for example, 'logic', 'logic block', 'part', 'portion', or 'circuit'. A module may be a single integral component, or a minimum unit or part thereof, adapted to perform one or more functions. For example, according to an embodiment, the module may be implemented in a form of an application-specific integrated circuit (ASIC).

Various embodiments of the disclosure may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory CD-ROM), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory 130 of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a printed circuit board;
a chip antenna disposed on the printed circuit board;
a conductive member disposed on the printed circuit board and including a cover portion positioned over the chip antenna, the cover portion including a first opening aligned with the chip antenna;
a non-conductive layer disposed on the cover portion to close the first opening; and
a shielding layer disposed on the non-conductive layer, and
wherein the shielding layer includes a second opening aligned with the first opening of the cover portion.

2. The electronic device of claim 1, wherein:
the cover portion of the conductive member includes a first area and a second area divided based on an imaginary line passing through a center of the chip antenna;
a size of the first area is larger than a size of the second area; and
a size of a first section of the shielding layer disposed on at least a portion of the first area is larger than a size of a second section of the shielding layer disposed on at least a portion of the second area.

3. The electronic device of claim 2, wherein:
the printed circuit board includes a center based on the imaginary line; and
the center of the chip antenna is located in a first direction from the center of the printed circuit board.

4. The electronic device of claim 3, wherein a center of the first opening is located in the first direction or a second direction opposite to the first direction from the center of the cover portion.

5. The electronic device of claim 4, wherein the center of the chip antenna is substantially coincident with the center of the first opening.

6. The electronic device of claim 4, wherein the center of the chip antenna is closer to the center of the printed circuit board than the center of the first opening.

7. The electronic device of claim 4, wherein the center of the chip antenna is farther from the center of the printed circuit board than the center of the first opening.

8. The electronic device of any one of claims 3 to 6, comprising:
a housing on which the printed circuit board is disposed, and
wherein sides of the housing include a long side and a short side connected to the long side,
and
the first direction is a direction substantially parallel to the short side.

9. The electronic device of any one of claims 3 to 8, wherein
the cover portion of the conductive member includes a plurality of openings; and
a center of each of the plurality of openings is located in the second direction from the center of the chip antenna.

10. The electronic device of claim 9, wherein the center of each of the plurality of openings is located on the first area of the cover portion.

11. The electronic device of claim 9, wherein:
the non-conductive layer includes sections overlapping the plurality of openings; and
the shielding layer includes sections overlapped on the sections of the non-conductive layer.

12. The electronic device of any one of claims 1 to 11, comprising:
a shield can disposed on the printed circuit board, and
wherein the cover portion of the conductive member is located on the shield can.

13. The electronic device of claim 12, wherein the shield can includes a side wall facing a side of the chip antenna.

14. The electronic device of any one of claims 1 to 13, comprising an antenna pattern disposed on the shielding layer.

15. The electronic device of claim 14, comprising a protective layer disposed on the antenna pattern, the protective layer including a section overlapping the second opening of the shielding layer.
